# EUROPÄISCHE PATENTSCHRIFT

(11) **EP 3 613 135 B1**
(45) Veröffentlichungstag und Bekanntmachung des Hinweises auf die Patenterteilung: **18.11.2020**
(21) Anmeldenummer: 19723399.2
(22) Anmeldetag: 10.05.2019
(51) Int. Cl.: H02M 7/10, H02M 7/25, H03K 17/74, F02P 3/08

(54) **SCHALTUNG ZUM SCHALTEN EINER WECHSELSPANNUNG**
CIRCUIT FOR SWITCHING AN AC VOLTAGE
CIRCUIT POUR COMMUTER UNE TENSION CA

(30) Priorität: 10.07.2018 DE 102018116597
(43) Veröffentlichungstag der Anmeldung: 26.02.2020
(73) Patentinhaber: Rosenberger Hochfrequenztechnik GmbH & Co. KG, 83413 Fridolfing (DE)
(72) Erfinder: FUCHS, Martin, 83395 Freilassing (DE); HUBER, Christoph, 83413 Fridolfing (DE); WINKLER, Johannes, 83373 Taching am See (DE); GRÖGER, Sven, 44797 Bochum (DE); VAN DELDEN, Marcel Johannes, 44789 Bochum (DE); NOTZON, Gordon, 44801 Bochum (DE); MUSCH, Thomas, 44879 Bochum (DE)
(86) Internationale Anmeldenummer: PCT/EP2019/061994
(87) Internationale Veröffentlichungsnummer: WO 2020/011417

(56) Entgegenhaltungen:
- EP-A1- 0 455 130
- EP-A1- 2 881 579
- KR-A- 20060 090 330
- US-A- 2 817 772
- US-A- 4 979 232
- US-A- 5 654 679
- US-A- 5 978 049

## Beschreibung

### GEBIET DER ERFINDUNG

Die vorliegende Erfindung betrifft eine Schaltung zum Schalten einer Wechselspannung.

### TECHNISCHER HINTERGRUND

Zum Schalten einer hochfrequenten Spannung wird bevorzugt eine Pin-Diode verwendet, wie beispielsweise in der KR 101594517 B1 dargestellt ist. Eine derartige pin-Diode weist zwischen einem P-dotierten Bereich und einem N-dotierten Bereich einen sogenannten intrinsischen Bereich auf. Bei einer in Durchlassrichtung vorgespannten pin-Diode wird in diesem intrinsischen Bereich eine vielfache Konzentration von Ladungsträgern aus den P-dotierten und N-dotierten Bereichen gegenüber der im intrinsischen Bereich intrinsisch bereits vorhandenen Ladungsträgerkonzentration injiziert. Diese hohe Ladungsträger-Injektion aus den P-dotierten und N-dotierten Bereichen verlagert das elektrische Feld vom P-dotierten bzw. N-dotierten Bereich tief in den intrinsischen Bereich hinein. Dies bewirkt eine Beschleunigung des Ladungsträgertransportes innerhalb der pin-Diode und damit ihre Eignung für Hochfrequenzanwendungen. Insbesondere bei höheren Frequenzen ab 10 MHz verliert die pin-Diode gegenüber einer normalen pn-Diode ihre Gleichrichtwirkung. Die Rekombinationszeit einer pin-Diode, d.h. die nötige Zeit zum vollständigen Ausräumen der hohen Konzentration an injizierten Ladungsträgern aus dem intrinsischen Bereich, ist gegenüber einer normalen pn-Diode deutlich höher.

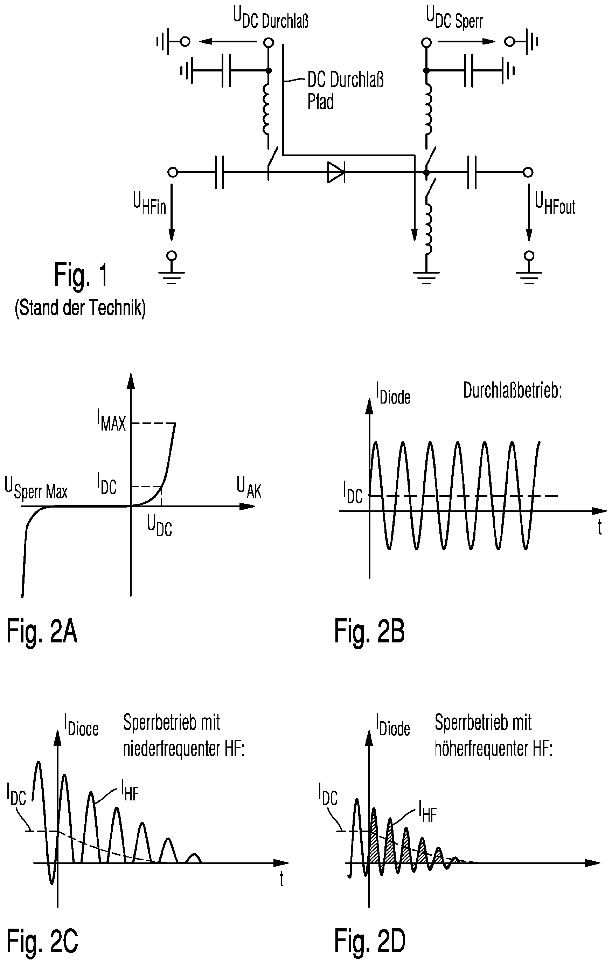

Eine pin-Diode, die entsprechend ihrer Kennliniencharakteristik gemäß Fig. 2A im Durchlassbetrieb mit einer Gleichspannung U_{DC} vorgespannt ist und somit einen für den Durchlassbetrieb nötigen Diodengleichstrom I_{DC} führt, ist somit bei Anliegen einer höherfrequenten Wechselspannung gemäß Fig. 2B selbstleitend. Die Ladungsträger im intrinsischen Bereich können dem schnellen Richtungswechsel der höherfrequenten Wechselspannung nicht mehr folgen. Die pin-Diode verhält sich faktisch wie ein durch die Gleichspannung U_{DC} gesteuerter Widerstand.

Diese selbstleitende Charakteristik der pin-Diode bei Anliegen einer höherfrequenten Wechselspannung bewirkt aber den Nachteil, dass die pin-Diode sich nicht von selbst sperren kann. Wie aus Fig. 1 hervorgeht, wird für den Betrieb einer pin-Diode nicht nur ein Gleichspannungsnetzwerk zur Vorspannung der pin-Diode in Durchlassrichtung, sondern nachteilig auch ein Gleichspannungsnetzwerk zur Vorspannung der pin-Diode in Sperrrichtung benötigt.

Der damit verbundene höhere Aufwand einer zusätzlichen Gleichspannungsquelle und von zusätzlichen Spulen, die eine Einspeisung des hochfrequenten Signals in das Gleichspannungsnetzwerk verhindern, stellt in kostensensiblen Applikationsfeldern wie beispielsweise im Automobilbereich ein deutliches Anwendungshindernis dar.

Aus der WO 01/35530 A2 ist eine Schaltung bekannt, in der der Zustand eines Hochfrequenzübertragungspfads über eine Serienschaltung aus einem Kondensator und einer pin-Diode zwischen sperrend und leitend gesteuert wird. Die Serienschaltung aus dem Kondensator und der pin-Diode ist zwischen dem Hochfrequenzübertragungspfad und einem Massepotential geschaltet. Die pin-Diode spannt sich durch ihre Selbstgleichrichtung selbst auf die Hochfrequenzspitzenspannung vor, so dass keine extern zugeführte negative Vorspannung mehr notwendig ist.

Durch die Serienschaltung aus Kondensator und pin-Diode zwischen dem Hochfrequenzübertragungspfad und dem Massepotential liegt bei gesperrter pin-Diode für das Hochfrequenzsignal eine Stichleitung vom Hochfrequenzübertragungspfad über den Kondensator bis zur gesperrten pin-Diode vor. Ein vom Hochfrequenzübertragungspfad in die Stichleitung eingekoppeltes Hochfrequenzsignal wird an der gesperrten pin-Diode reflektiert und überlagert sich mit einem Phasenversatz dem direkt über den Hochfrequenzübertragungspfad übertragenen Hochfrequenzsignal. Durch eine derartige Beschaltung der pin-Diode wird das Hochfrequenzübertragungsverhalten des Hochfrequenzübertragungspfades erheblich verschlechtert.

Im gesperrten Zustand des Hochfrequenzübertragungspfads, d.h. bei leitender pin-Diode, fließt ein hoher Strom über die Serienschaltung zum Massepotential. Um diese hohe Stromtragfähigkeit zu realisieren, ist ein erheblicher Aufwand bei der Auslegung des Hochfrequenzverstärkers, der Kondensators und die pin-Diode zu tätigen.

Darüber hinaus ist durch eine derartige Beschaltung einer pin-Diode ergänzend zum Auskopplungskondensator zusätzlich der Kondensator der Serienschaltung erforderlich, so dass hiermit keine bauteilminimierte Lösung vorliegt.

Schließlich werden für eine Verteilerschaltung, in der die Eingänge von mehreren parallel geschalteten Hochfrequenzübertragungspfaden an einen gemeinsamen Eingangsanschluss geschaltet sind, bei einer derartigen Beschaltung der pin-Diode im Fall von mindestens einer leitenden pin-Diode alle parallel geschalteten Hochfrequenzübertragungspfade gesperrt. Sind mehrere pin-Dioden aufgrund eines Ansteuerfehlers gleichzeitig gesperrt, so können mehrere Hochfrequenzübertragungspfade gleichzeitig leitend sein. Eine derartige Beschaltung einer pin-Diode ist folglich für eine Verteilerschaltung, in der stets ein einziger Hochfrequenzübertragungspfad leitend und alle übrigen Hochfrequenzübertragungspfade gesperrt sind, nicht geeignet.

Aus der EP 0 455 130 A1 ist ebenfalls eine Schaltung bekannt, in der der Zustand eines Hochfrequenzübertragungspfads über eine Serienschaltung aus einem Kondensator und einer pin-Diode zwischen sperrend und leitend gesteuert wird. Die Serienschaltung aus dem Kondensator und der pin-Diode ist hierbei im Hochfrequenzübertragungspfad geschaltet.

Die US 4 979 232 A offenbart eine Schaltung mit einer pin-Diode, in der die Spannung zur Vorspannung der pin-Diode in Sperrrichtung aus dem zu übertragenden Hochfrequenzstrom über eine Spannungsduplizier-Schaltung erzeugt wird.

Aus der KR 2006 009 0330 A geht eine Schaltung mit einer pin-Diode hervor, in der im Durchlassbetrieb der pin-Diode eine in Durchlassrichtung gepolte Vorspannung und im Sperrbetrieb der pin-Diode eine in Sperrrichtung gepolte Vorspannung an die pin-Diode geschaltet wird.

Die US 2 817 772 A beschreibt eine Schaltung mit mehreren in Serie geschalteten Kapazitätsdioden, in der im Durchlassbetrieb der Kapazitätsdioden an die Anode der einzelnen Kapazitätsdioden jeweils eine in Durchlassrichtung der Kapazitätsdiode gepolte Vorspannung und im Sperrbetrieb der Kapazitätsdioden an die Kathode der einzelnen Kapazitätsdioden jeweils eine in Sperrrichtung der Kapazitätsdiode gepolte Vorspannung geschaltet wird.

Aus der US 2 817 772 A ist eine Schaltung mit zwei parallelen Dioden bekannt, in der über einen einzigen Schalter zwischen den beiden Dioden geschaltet wird.

Die EP 2 881 579 A1 offenbart eine Schaltung zur Ansteuerung von mehreren Zündkerzen in einer Verbrennungskraftmaschine. Die Schaltung zur Ansteuerung enthält hierbei eine Einheit zur Erzeugung, Verstärkung und Verteilung eines Hochfrequenzsignals.

Die US 5 654 679 A offenbart eine Anpassschaltung zur Impedanzanpassung einer variablen Lastimpedanz an eine feste Impedanz einer Hochfrequenzquelle.

Dies ist ein Zustand, den es zu verbessern gilt.

### ZUSAMMENFASSUNG DER ERFINDUNG

Vor diesem Hintergrund liegt der vorliegenden Erfindung die Aufgabe zugrunde, eine aufwandsminimierte Schaltung für eine Diode anzugeben, mit der eine Wechselspannung geschaltet werden kann.

Erfindungsgemäß wird diese Aufgabe durch eine Schaltung zum Schalten einer Wechselspannung mit den Merkmalen des Patentanspruchs 1 gelöst.

In der folgenden Beschreibung können die Ausdrücke "Ausführungsform", "Ausführungsbeispiel", "Variante" und "Erweiterung" für Gegenstände benutzt worden sein, die nicht in den Schutzumfang der Ansprüche fallen. Nur Beispiele, die alle Merkmale des unabhängigen Anspruchs enthalten, sind Teil der Erfindung und damit "Ausführungsformen", "Ausführungsbeispiele", "Varianten" und "Erweiterungen". Teile der Beschreibung die nicht in den Schutzumfang der Ansprüche fallen stellen den Stand der Technik dar und/oder dienen dem Verständnis der Erfindung.

Beispielhaft ist vorgesehen: Eine Schaltung zum Schalten einer Wechselspannung umfassend
- einen mit einer Wechselspannungsquelle verbindbaren Eingangsanschluss,
- einen mit einer Lastimpedanz verbindbaren Ausgangsanschluss,
- einer ersten Serienschaltung umfassend eine Diode und eine Schaltung zum Speichern von elektrischen Ladungen,
- wobei die erste Serienschaltung einen ersten Endanschluss, der mit dem Eingangsanschluss verbunden ist, und einen zweiten Endanschluss aufweist, der mit dem Ausgangsanschluss verbunden ist,
- einer Gleichspannungsquelle, welche an eine elektrische Verbindung zwischen der Diode und dem Eingangsanschluss oder an einer elektrischen Verbindung zwischen der Diode und dem Ausgangsanschluss angeschlossen ist und
- derart eingerichtet ist, einen Gleichstrom in der Diode einzuprägen,
- und einen ersten Schalter, welcher mit einem Anschluss an einer elektrischen Verbindung zwischen der Diode und der Schaltung zum Speichern von elektrischen Ladungen angeschlossen ist und
- welcher derart eingerichtet ist, zwischen einem Schaltzustand, in dem ein von einem Bezugspotential abhängiges Potential an der elektrischen Verbindung zwischen der Diode und der Schaltung zum Speichern von elektrischen Ladungen anliegt, und einem Schaltzustand, in dem ein elektrisches Schwebepotential in der elektrischen Verbindung zwischen der Diode und der Schaltung zum Speichern von elektrischen Ladungen anliegt, zu schalten.

Die der vorliegenden Erfindung zugrundeliegende Erkenntnis/Idee besteht darin, dass durch das Öffnen des ersten Schalters in der elektrischen Verbindung zwischen der Diode und der Schaltung zum Speichern von elektrischen Ladungen ein elektrisches Schwebepotential vorliegt.

Ein elektrisches Schwebepotential in einem Schaltungsknoten einer elektrischen Schaltung oder in einer elektrischen Verbindung zwischen zwei Schaltungselementen einer Schaltung liegt dann vor, wenn der Schaltungsknoten oder die elektrische Verbindung für einen Gleichstrom keine leitende elektrische Verbindung zu einem Bezugspotential der Schaltung aufweist. Der Schaltungsknoten oder die elektrische Verbindung ist somit von jedem Bezugspotential der Schaltung getrennt und damit unabhängig von einem Bezugspotential.

Weder die Schaltung zum Speichern von elektrischen Ladungen noch der geöffnete erste Schalter ermöglicht für einen Gleichstrom einen Stromdurchfluss und stellt somit für einen Gleichstrom keine leitende elektrische Verbindung zu einem Bezugspotenzial der Schaltung dar. Damit in der elektrischen Verbindung zwischen der Diode und der Schaltung zum Speichern von elektrischen Ladungen ein elektrisches Schwebepotenzial vorliegt, muss die Diode bei geöffneten ersten Schalter in den Sperrzustand gelangen, ohne dass hierfür eine zusätzliche elektrische Verbindung zu einem Bezugspotenzial der Schaltung vorliegt.

Dies ist möglich, da der von der Gleichspannungsquelle in die Diode eingeprägte Gleichstromanteil I_{DC} und der von der Wechselspannungsquelle in die Diode eingeprägte Wechselstromanteil I_{HF} mit Öffnen des ersten Schalters nicht abrupt, sondern in einem transienten Vorgang mit einer Zeitkonstante auf den Wert null abfällt. Diese Zeitkonstante ergibt sich primär aus dem Durchgangswiderstand der Diode und der Kapazität der Schaltung zum Speichern von elektrischen Ladungen. Während dieses verzögerten Abfalls des Diodenstroms wird die mit der Diode verbundene Schaltung zum Speichern von elektrischen Ladungen mit den elektrischen Ladungen des Diodenstroms auf eine bestimmte Spannung aufgeladen, die ab einem bestimmten Wert als Sperrspannung für die Diode dient.

Für den Fall, dass eine niederfrequente Wechselspannung an die Diode angelegt wird, tritt in der Diode ein Gleichrichteffekt auf. Die Diode ist nur bei Anliegen einer positiven Anoden-Kathoden-Spannung leitend. Wie aus Fig. 2C für diesen Fall hervorgeht, enthält der Diodenstrom nur positive Stromanteile, die sich aus dem Gleichstromanteil I_{DC} und dem überlagerten Wechselstromanteil I_{HF} zusammensetzen. Sowohl der Gleichstromanteil I_{DC} als auch der überlagerte Wechselstromanteil I_{HF} gehen jeweils mit der Zeitkonstante gegen null. Über diesen Zeitraum wird die Schaltung zum Speichern von elektrischen Ladungen mit dem positiven Diodenstrom aufgeladen. Ein Entladen der Schaltung zum Speichern von elektrischen Ladungen über diesen Zeitraum findet wegen Fehlen eines negativen Diodenstroms nicht statt.

Im Fall einer höherfrequenten Wechselspannung, d.h. einer Wechselspannung mit einer Frequenz zwischen 0,3 MHz und 30 GHz, ist die Diode als pin-Diode ausgeführt. In diesem Fall tritt an der pin-Diode kein Gleichrichteffekt auf. Wie aus Fig. 2D ersichtlich ist, fließt über den gesamten Zeitraum, in der sowohl der Gleichstromanteil I_{DC} als auch der überlagerte Wechselstromanteil I_{HF} jeweils mit der Zeitkonstante gegen null abfällt, ein Diodenstrom ohne Unterbrechung durch die pin-Diode. Somit kommt es in diesem Zeitraum sowohl zu einem Aufladen als auch einem Entladen der Schaltung zum Speichern von elektrischen Ladungen. Aufgrund eines positiven Gleichstromanteils I_{DC} sind aber die der Schaltung zum Speichern von elektrischen Ladungen zugeführten freien Ladungsträger des Diodenstroms in Summe größer als die der Schaltung zum Speichern von elektrischen Ladungen entzogenen Ladungsträger (siehe hierzu auch die der Ladung entsprechende Fläche unter dem Gesamtdiodenstrom in Fig. 2D). Somit wird auch in diesem Fall die Schaltung zum Speichern von elektrischen Ladungen auf eine ausreichende Spannung aufgeladen, die eine ausreichende Sperrspannung zum Sperren der Diode darstellt.

Somit wird in beiden Fällen vorteilhaft eine Selbstsperrung der Diode bzw. der pin-Diode ohne Beaufschlagung der Diode bzw. der pin-Diode mit einer Gleichspannung in Sperrrichtung durch eine Bezugspotenzialquelle erzielt.

Erfindungsgemäß ist ein erster Endanschluss der ersten Serienschaltung mit dem Eingangsanschluss und ein zweiter Endanschluss der ersten Serienschaltung mit dem Ausgangsanschluss verbunden. Somit ist die erste Serienschaltung in den Hochfrequenzübertragungspfad integriert. In einer Verteilerschaltung mit mehreren parallel geschalteten Hochfrequenzübertragungspfaden ist immer nur ein einziger Hochfrequenzübertragungspfad und damit eine einzige pin-Diode leitend, während alle übrigen Hochfrequenzübertragungspfade bzw. pin-Dioden gesperrt sind. Somit fließt bei einer Verteilerschaltung mit einer in den Hochfrequenzübertragungspfad integrierten ersten Serienschaltung zu jedem Betriebszeitpunkt einzig in einer pin-Diode ein Strom, während bei einer Verteilerschaltung mit einer Schaltungsrealisierung gemäß der WO 01/35530 A2 in mehreren Dioden jeweils ein Strom fließt. Die erfindungsgemäße Schaltungsrealisierung ist somit gegenüber dem Stand der Technik vorteilhaft hinsichtlich des Energieverbrauchs minimiert.

Eine Einprägung eines Gleichstromes in der Diode durch die Gleichspannungsquelle erfolgt wie üblich durch einen zwischen der Gleichspannungsquelle und der Diode geschalteten Widerstand. Alternativ kann die Einprägung eines Gleichstromes auch durch eine Gleichstromquelle erfolgen. Schließlich ist auch eine parallele Realisierung einer Gleichspannungsquelle und einer Gleichstromquelle möglich.

Zur Einprägung des Gleichstroms in die Diode ist die Gleichspannungsquelle an eine elektrische Verbindung zwischen dem Eingangsanschluss und der Diode oder an eine elektrische Verbindung zwischen dem Ausgangsanschluss und der Diode angeschlossen.

Unter einer elektrischen Verbindung ist hierbei eine direkte elektrische Verbindung zwischen der Diode und dem Eingangsanschluss bzw. dem Ausgangsanschluss beispielsweise mittels einer auf einer Leiterplatte oder einem Substrat realisierten Leiterbahn bzw. Streifenleitung oder mittels eines (Bond-)Drahtes zu verstehen. Daneben ist unter einer elektrischen Verbindung auch eine für die Übertragung insbesondere einer Wechselspannung bzw. einer Hochfrequenzspannung geeignete elektrisch leitfähige Verbindung zwischen der Diode und dem Eingangsanschluss bzw. dem Ausgangsanschluss zu verstehen, in die zusätzliche elektronische Bauelemente, beispielsweise Kondensatoren oder Widerstände, zwischengeschaltet sind. Dieselbe Definition für eine elektrische Verbindung gilt auch für die elektrische Verbindung zwischen der Diode und der Schaltung zum Speichern von elektrischen Ladungen.

Der Anschluss der Gleichspannungsquelle an die elektrische Verbindung zwischen dem Eingangsanschluss und der Diode oder an die elektrische Verbindung zwischen dem Ausgangsanschluss und der Diode kann hierbei im Idealfall direkt ohne Zwischenschaltung zusätzlicher Bauelemente bzw. Schaltungen erfolgen. Im Idealfall beinhaltet der Anschluss der Gleichspannungsquelle an die elektrische Verbindung, wie noch in den einzelnen Ausführungsformen und Varianten der erfindungsgemäßen Schaltung gezeigt wird, auch ein Zwischenschalten von weiteren Bauelementen bzw. Schaltungen. Diese Definition eines Anschlusses bzw. eines Verbindens eines elektronischen Bauelements an eine elektrische Verbindung gilt für alle weiteren in der Patentanmeldung noch verwendeten äquivalenten Formulierungen in gleicher Weise.

Der erste Schalter, welcher mit einem Anschluss an einer elektrischen Verbindung zwischen der Diode und der Schaltung zum Speichern von elektrischen Ladungen angeschlossen ist, ist bevorzugt zwischen zwei Schaltzuständen schaltbar. In einem ersten Schaltzustand des ersten Schalters liegt in der elektrischen Verbindung zwischen der Diode und der Schaltung zum Speichern von elektrischen Ladungen ein von einem Bezugspotenzial abhängiges (elektrisches) Potenzial. Das Potenzial kann hierbei dem Bezugspotenzial entsprechen oder über einen Faktor vom Bezugspotenzial abhängig sein. Das Bezugspotenzial wie auch der Faktor sind jeweils bevorzugt fixe Größen. In Abhängigkeit der spezifischen Applikation der erfindungsgemäßen Schaltung kann das Bezugspotenzial und/oder der Faktor auch zeitlich veränderlich oder von anderen Parametern, beispielsweise der Umgebungstemperatur der Schaltung, abhängig und damit veränderlich sein. Abhängig von spezifischen Applikationsanforderungen kann der erste Schalter auch mehr als zwei Schaltzustände aufweisen.

Der erste Schalter ist jeweils als elektronischer Schalter, bevorzugt als Schalttransistor, verwirklicht. Ein derartiger Schalttransistor ist entweder in Bipolartechnologie oder als Feldeffekttransistor realisiert. Daneben kann ein derartiger elektronischer Schalter als Diode, Halbleiterrelais oder Thyristor verwirklicht sein. Die zum ersten Schalter erwähnten Ausprägungen gelten für die weiter noch zu beschreibenden Schalter äquivalent.

Als Bezugspotenzial wird bevorzugt das Massepotenzial der Schaltung verwendet. Alternativ kann auch ein vom Massepotenzial abweichendes Bezugspotenzial gewählt werden. Die Höhe des Bezugspotenzial ist hierbei in Abhängigkeit des von der Gleichspannungsuelle erzeugten Gleichspannungspegels und der Parameter der im Gleichstromdurchlasspfad verwendeten elektronischen Bauelemente so zu wählen, dass ein ausreichender Diodengleichstrom I_{DCDurchlaß} durch die Diode fließen kann.

Der Eingangsanschluss der erfindungsgemäßen Schaltung, der als Wechselspannungs-Eingangsanschluss, bevorzugt als Hochfrequenz-Eingangsanschluss, dient, ist mit einer Wechselspannungs- bzw. Hochfrequenzspannungsquelle verbindbar. Dies kann beispielsweise ein Frequenzoszillator oder eine elektronische Schaltung sein, an deren Ausgang eine Wechselspannung bzw. Hochfrequenzspannung anliegt. Neben einer Wechselspannungsquelle ist auch alternativ eine Wechselstromquelle oder eine Schaltung möglich, die an ihrem Ausgang einen Wechselstrom erzeugt.

Der Ausgangsanschluss der erfindungsgemäßen Schaltung ist mit einer Lastimpedanz verbindbar. Im Automobilbereich kann die erfindungsgemäße Schaltung benutzt werden, eine hochfrequente Wechselspannung an eine Schaltung durchzuschalten, in der die hochfrequente Wechselspannung einem Hochspannungspuls überlagert wird. Der mit einer Hochfrequenzspannung überlagerte Hochspannungspuls dient zur Ansteuerung einer Zündkerze. Die Lastimpedanz ergibt sich in diesem Anwendungsfall mindestens aus einer Leitungsimpedanz einer zwischen der erfindungsgemäßen Schaltung und der elektrischen Zündkerze befindlichen Hochfrequenzleitung, der Impedanz des in der elektrischen Zündkerze befindlichen Innenleiters, zusätzlichen parasitären Kapazitäten und der im Verbrennungsraum zwischen den beiden Zündkerzenelektroden herrschenden Impedanz.

Vorteilhafte Ausgestaltungen und Weiterbildungen ergeben sich aus den weiteren Unteransprüchen sowie aus der Beschreibung unter Bezugnahme auf die Figuren der Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

In einer bevorzugten Ausprägung der erfindungsgemäßen Schaltung ist der erste Schalter als ein erster Ein-Schalter oder als ein erster Aus-Schalter ausgeführt.

Bei einem Ein-Schalter ist in einem ersten Schaltzustand, d.h. bei einer aktivierten Ansteuerung des Ein-Schalters, eine geschlossene elektrische Kontaktverbindung zwischen den beiden Anschlüssen des Schalters verwirklicht und somit der Schalter geschlossen. In einem zweiten Schaltzustand, d.h. bei einer nicht aktivierten Ansteuerung des Ein-Schalters, ist bei einem Ein-Schalter eine geöffnete elektrische Kontaktverbindung zwischen den beiden Anschlüssen des Schalters verwirklicht und somit der Schalter geöffnet. Bei einem Aus-Schalter sind die Schaltzustände zu den Schaltzuständen des Ein-Schalters invertiert. In einem ersten Schaltzustand, d.h. bei einer aktivierten Ansteuerung des Aus-Schalters, ist bei dem Aus-Schalter eine geöffnete elektrische Kontaktverbindung zwischen den beiden Anschlüssen des Schalters verwirklicht und somit der Schalter geöffnet. In einem zweiten Schaltzustand, d.h. einer nicht aktivierten Ansteuerung des Aus-Schalters, ist eine geschlossene elektrische Kontaktverbindung zwischen den beiden Anschlüssen des Schalters verwirklicht und somit der Schalter geschlossen.

Ist der eine Anschluss des ersten Schalters, welcher als Ein-Schalter oder als Aus-Schalter realisiert ist, mit einem Bezugspotenzial verbunden, während der andere Anschluss des ersten Schalters mit der elektrischen Verbindung zwischen der Diode und der Schaltung zum Speichern von elektrischen Ladungen verbunden ist, so ist die elektrische Verbindung zwischen der Diode und der Schaltung zum Speichern von elektrischen Ladungen in einem Schaltzustand mit einem Bezugspotenzial elektrisch verbunden und im anderen Schaltzustand vom Bezugspotenzial elektrisch getrennt. Im einem Schaltzustand liegt somit in der elektrischen Verbindung zwischen der Diode und der Schaltung zum Speichern von elektrischen Ladungen ein Bezugspotenzial oder ein von einem Bezugspotenzial abhängiges elektrisches Potenzial vor. Im anderen Schaltzustand liegt in der elektrischen Verbindung zwischen der Diode und der Schaltung zum Speichern von elektrischen Ladungen nach dem Ende des transienten Vorgangs, in dem nach dem Öffnen des ersten Schalters die Sperrung der Diode erfolgt ist, ein elektrisches Schwebepotenzial vor.

Neben einem Ein-Schalter oder einem Aus-Schalter kann der erste Schalter auch als Wechselschalter realisiert sein. In diesem Fall wird der Anschluss, der mit der elektrischen Verbindung zwischen der Diode und der Schaltung zum Speichern von elektrischen Ladungen verbunden ist, entweder mit einem ersten weiteren Anschluss, der mit einem Bezugspotenzial verbunden ist, oder mit einem zweiten weiteren Anschluss verbunden, der mit keinem Potenzial, insbesondere mit keinem Bezugspotenzial, verbunden ist. Der zweite weitere Anschluss des Wechselschalters ist in diesem Fall "offen geschaltet".

In einer weiteren bevorzugten Ausführungsform der erfindungsgemäßen Schaltung ist zwischen der Gleichspannungsquelle, die einen Gleichstrom in der Diode einprägt, und der elektrischen Verbindung zwischen der Diode und dem Eingangsanschluss bzw. der elektrischen Verbindung zwischen der Diode und dem Ausgangsanschluss eine Schaltung mit einer Tiefpassfiltercharakteristik oder eine Schaltung mit einem Widerstand geschaltet. Ebenso ist zwischen dem ersten Schalter und der elektrischen Verbindung zwischen der Diode und der Schaltung zum Speichern von elektrischen Ladungen eine Schaltung mit einer Tiefpassfiltercharakteristik oder eine Schaltung mit einem Widerstand geschaltet.

Bei der Schaltung mit einer Tiefpassfiltercharakteristik handelt es sich um eine Schaltung, deren Übertragungscharakteristik der eines Tiefpassfilters entspricht. Diese Schaltung ist somit für Signale bzw. Signalanteile mit einer Frequenz unterhalb der Grenzfrequenz des Tiefpassfilters durchlässig und für Signale bzw. Signalanteile mit einer Frequenz oberhalb der Grenzfrequenz des Tiefpassfilters sperrend oder zumindest dämpfend. Als Schaltung mit einer Tiefpassfiltercharakteristik wird bevorzugt eine Spule verwendet. Bei der Spule handelt es sich bevorzugt jeweils um eine Zylinderspule ohne integrierten Ferritkern, d.h. eine Luftspule. Daneben kann auch eine Zylinderspule mit integrierten Ferritkern oder eine Spule mit anders geformten und gewickelten Windungen Verwendung finden.

Die Spule, die zwischen dem ersten Schalter und der elektrischen Verbindung zwischen der Diode und der Schaltung zum Speichern von elektrischen Ladungen geschaltet ist, wird im Folgenden als erste Spule bezeichnet. Die Spule, die zwischen der Gleichspannungsquelle und der elektrischen Verbindung zwischen dem Eingangsanschluss und der Diode oder zwischen der Gleichspannungsquelle und der elektrischen Verbindung zwischen dem Ausgangsanschluss und der Diode geschaltet ist, wird im Folgenden als zweite Spule bezeichnet.

Bei der Schaltung mit einem Widerstand kann es sich beispielsweise um einen Bonddraht handeln, der in einem hohen Frequenzbereich ein induktives Verhalten aufweist. Alternativ kann es sich bei der Schaltung mit einem Widerstand auch um eine Streifenleitung handeln, die als so genannter Butterfly-Stub ausgeführt ist, und somit ebenfalls in einem höheren Frequenzbereich ein induktives Verhalten aufweist.

Sowohl die Schaltung mit Tiefpassfiltercharakteristik wie auch die Schaltung mit einem Widerstand verhindert einen Abfluss der am Eingangsanschluss eingespeisten Wechselspannung einerseits in Richtung der Gleichspannungsquelle und andererseits in Richtung des ersten Schalters und damit in Richtung des Bezugspotenzials. Somit fließt die am Eingangsanschluss eingespeiste Wechselspannung einzig über die Diode bzw. die pin-Diode zum Ausgangsanschluss. Ein Kurzschließen der eingespeisten Wechselspannung zur Gleichspannungsquelle oder zum Bezugspotenzial wird verhindert.

Die Schaltung zum Speichern von elektrischen Ladungen ist bevorzugt ein Kondensator, der elektrische Ladungen speichern kann. Alternativ kann die Schaltung zum Speichern von elektrischen Ladungen auch eine Anordnung von Kondensatoren beinhalten. Neben einem Kondensator kann als Schaltung zum Speichern von elektrischen Ladungen alternativ auch eine Kapazitätsdiode oder das Gate eines MOS-Feldeffekttransistor verwendet werden.

In einer ersten Erweiterung der erfindungsgemäßen Schaltung ist zwischen dem Bezugspotenzial und der elektrischen Verbindung zwischen der Diode und der Schaltung zum Speichern von elektrischen Ladungen eine Serienschaltung aus einer dritten Spule und einer Verschaltung von mehreren weiteren Kondensatoren vorgesehen.

Die weiteren Kondensatoren werden mit dem Öffnen des ersten Schalters, d.h. im Übergang zwischen dem Durchlass- und dem Sperrbetrieb der Diode, in eine Parallelverschaltung überführt. Hierzu sind diodenseitig, d.h. in der elektrischen Verbindung zur Diode, zwischen den weiteren Kondensatoren jeweils zweite Schalter und auf der Seite des Bezugspotenzial, d.h. in der elektrischen Verbindung zum Bezugspotenzial, jeweils dritte Schalter verschaltet, die jeweils geschlossen sind. Gleichzeitig sind zwischen den weiteren Kondensatoren jeweils vierte Schalter geschaltet, die jeweils geöffnet sind.

Der Kondensator und die parallel geschalteten weiteren Kondensatoren werden mit dem Ladungsfluss durch die Diode jeweils auf eine gleiche Kondensatorspannung aufgeladen. Sobald diese Kondensatorspannung am Kondensator und allen parallel geschalteten weiteren Kondensatoren jeweils einen bestimmten Spannungspegel erreicht hat, wird die Parallelverschaltung der weiteren Kondensatoren in eine Serienverschaltung überführt. Hierzu werden die zweiten und dritten Schalter jeweils geöffnet und gleichzeitig die vierten Schalter geschlossen.

Durch die Serienverschaltung der weiteren Kondensatoren liegt über alle seriell verschalteten weiteren Kondensatoren eine Kondensatorgesamtspannung an, die einem der Anzahl von seriell geschalteten weiteren Kondensatoren entsprechenden Vielfachen einer Kondensatoreinzelspannung entspricht. Somit kommt es zu einem Ausgleichsvorgang zwischen der höheren Kondensatorgesamtspannung der seriell verschalteten weiteren Kondensatoren und der niedrigeren Kondensatoreinzelspannung des Kondensators. Nach dem Ausgleichsvorgang stellt sich an der Diode eine Sperrspannung ein, die sich zwischen der Kondensatorgesamtspannung der seriell verschalteten weiteren Kondensatoren und der Kondensatoreinzelspannung des Kondensators befindet. Die in der ersten Erweiterung der erfindungsgemäßen Schaltung erzielbare Sperrspannung ist somit gegenüber der in der erfindungsgemäßen Grundschaltung erzielbaren Sperrspannung erhöht.

Die dritte Spule in der ersten Erweiterung der erfindungsgemäßen Schaltung verhindert ein Kurzschließen der an der Diode anliegenden Wechselspannung über die Verschaltung der weiteren ersten Kondensatoren mit dem Bezugs- bzw. Massepotenzial.

In einer bevorzugten zweiten Erweiterung der erfindungsgemäßen Schaltung zum Schalten einer Wechselspannung werden mit dem Öffnen des ersten Schalters im Übergang der Diode vom Durchlass- in den Sperrbetrieb zum Kondensator mehrere weitere Kondensatoren parallelgeschaltet. Die Parallelschaltung der weiteren Kondensatoren zum Kondensator erfolgt über zweite Schalter, die jeweils diodenseitig, d.h. in der elektrischen Verbindung zur Diode, zwischen zwei Kondensatoren geschaltet sind, und über dritte Schalter, die jeweils auf der Seite des Eingangs- oder Ausgangsanschlusses, d.h. in der elektrischen Verbindung zum Eingangs- oder zum Ausgangsanschluss, zwischen zwei Kondensatoren verschaltet sind.

In der zweiten Erweiterung der erfindungsgemäßen Schaltung erfolgt in der transienten Phase zwischen Durchlass- und Sperrbetrieb der Diode eine parallele Aufladung des Kondensators und der weiteren Kondensatoren. Hierbei werden der Kondensator und alle weiteren Kondensatoren jeweils auf die gleiche Kondensatorspannung aufgeladen. Weisen der Kondensator und die weiteren Kondensatoren bevorzugt eine gleiche Kapazität auf, so befindet sich auf dem Kondensator und auf allen weiteren parallel geschalteten Kondensatoren jeweils die gleiche Ladungsmenge.

Werden bei Erreichen eines bestimmten Kondensatorspannungspegels der Kondensator und die weiteren Kondensatoren jeweils in Serie geschaltet, so addieren sich die einzelnen Kondensatorspannungen. Auf diese Weise liegt an der Diode durch die Umschaltung der Kondensatoren von einer Parallelin eine Serienverschaltung eine der Anzahl der verwendeten Kondensatoren entsprechende höhere Sperrspannung an. Auf diese Weise ist vorteilhaft eine Sperrspannung erzielbar, die gegenüber der bei der Grundausführung und der ersten Erweiterung der erfindungsgemäßen Schaltung jeweils erzielbaren Sperrspannung erhöht ist und somit eine sichere Sperrung der Diode ermöglicht.

In der Parallelverschaltung des Kondensators und der weiteren Kondensatoren sind die zweiten und dritten Schalter jeweils geschlossen, während die vierten Schalter jeweils geöffnet sind. In der Serienverschaltung des Kondensators und der weiteren Kondensatoren sind die zweiten und dritten Schalter jeweils geöffnet und gleichzeitig die vierten Schalter geschlossen.

In einer dritten Erweiterung der erfindungsgemäßen Schaltung ist zwischen der Diode und der Serienschaltung aus erster Spule und ersten Schalter ein fünfter Schalter geschaltet.

Synchron zum ersten Schalter wird auch der fünfte Schalter geöffnet. Durch das Öffnen des ersten und fünften Schalters kommt es in der ersten Spule zu einem abrupten Stromabbruch, der in der ersten Spule eine Spannung induziert. Diese in der ersten Spule induzierte Spannung weist einen Spannungsabfall auf, der in Richtung der Diode gerichtet ist.

Ein sechster Schalter verbindet eine elektrische Verbindung, die den fünften Schalter mit der ersten Spule verbindet, mit einem Massepotential der Schaltung. Um die in der ersten Spule induzierte Spannung auf ein Bezugspotenzial zu beziehen, wird synchron oder zumindest zeitnah zum Öffnen des ersten und fünften Schalters der sechste Schalter geschlossen und damit der diodenseitige Anschluss der ersten Spule auf das Massepotential geführt.

Synchron oder zumindest zeitnah zum Schließen des sechsten Schalters wird ein siebter Schalter geschlossen, der zwischen der Diode und der elektrischen Verbindung zwischen der ersten Spule und dem ersten Schalter geschaltet ist. Im bevorzugten Fall eines gleichzeitigen Öffnens des ersten und fünften Schalters und gleichzeitigen Schließens des sechsten und siebten Schalters fließt in diesem Zeitpunkt der maximal mögliche Gleichstrom I_{DCDurchlass} durch die Diode. Die in der ersten Spule induzierte Spannung ist folglich aufgrund der maximal möglichen Stromänderung maximiert. Durch Schließen des siebten Schalters wird der Kondensator schnellstmöglich um die in der ersten Spule induzierte Spannung aufgeladen. An der Diode liegt somit schnellstmöglich eine Sperrspannung an, die gegenüber der in der erfindungsgemäßen Grundausführung und der ersten und zweiten Erweiterung der erfindungsgemäßen Schaltung jeweils erzielbaren Sperrspannung noch deutlich erhöht ist.

Ein Kurzschließen der in der ersten Spule induzierte Spannung über den fünften und siebten Schalter wird durch den "zusätzlichen" fünften Schalter verhindert, der während der Ladezeit des Kondensators geöffnet ist. Um auch ein Entladen des Kondensators im Anschluss an den Ladevorgang über den geschlossenen sechsten und siebten Schalter und die erste Spule an das Massepotential zu verhindern, wird der siebte Schalter nach der sehr kurzen Ladephase des Kondensators wieder geöffnet. Durch eine geeignete Dimensionierung der Induktivität der ersten Spule kann zusätzlich die Höhe der in der ersten Spule induzierten Spannung eingestellt werden.

Schließlich sei an dieser Stelle erwähnt, dass durch Zwischenschalten eines geeignet dimensionierten Widerstandes zwischen dem ersten Schalter und der elektrischen Verbindung zwischen der Diode und der Schaltung zum Speichern von elektrischen Ladungen das elektrische Potenzial in der elektrischen Verbindung zwischen der Diode und der Schaltung zum Speichern von elektrischen Ladungen bereits im Durchlassbetrieb der Diode erhöht werden kann. Auf diese Weise ist es vorteilhaft möglich, im Übergang zwischen dem Durchlass- und dem Sperrbetrieb der Diode in der erfindungsgemäßen Grundschaltung wie auch in allen Erweiterungen der erfindungsgemäßen Grundschaltung eine höhere Sperrspannung oder ein schnelleres Sperren der Diode zu erzielen.

In einer vierten Erweiterung der erfindungsgemäßen Schaltung zum Schalten einer Wechselspannung sind weitere erste Serienschaltungen umfassend jeweils eine weitere Diode und jeweils eine weitere Schaltung zum Speichern von elektrischen Ladungen vorgesehen. Jede weitere Serienschaltung weist jeweils einen ersten Endanschluss und einen zweiten Endanschluss auf. Der erste Endanschluss jeder weiteren Serienschaltung ist jeweils mit dem Eingangsanschluss verbunden. Der zweite Endanschluss jeder weiteren Serienschaltung ist jeweils mit einem weiteren Ausgangsanschluss verbunden, der jeweils mit einer weiteren Lastimpedanz verbindbar ist. Auf diese Weise lässt sich die am Eingangsanschluss eingespeiste Wechselspannung auf eine oder mehrere der Ausgangsanschlüsse schalten.

Um jede einzelne weitere Diode jeweils separat in Durchlass- oder Sperrrichtung zu schalten, ist für jede weitere Diode jeweils ein weiterer erster Schalter mit einem Anschluss an der elektrischen Verbindung zwischen der jeweiligen weiteren Diode und der jeweiligen weiteren Schaltung zum Speichern von elektrischen Ladungen angeschlossen. Der jeweilige weitere erste Schalter ist derart eingerichtet, zwischen einem Schaltzustand, in dem ein vom Bezugspotential abhängiges Potential in der elektrischen Verbindung zwischen der jeweiligen weiteren Diode und der jeweiligen weiteren Schaltung zum Speichern von elektrischen Ladungen anliegt, und einem Schaltzustand, in dem ein elektrisches Schwebepotential in der elektrischen Verbindung zwischen der jeweiligen weiteren Diode und der jeweiligen weiteren Schaltung zum Speichern von elektrischen Ladungen anliegt, zu schalten.

Wird durch den jeweiligen weiteren ersten Schalter ein vom Bezugspotenzial abhängiges Potenzial in die elektrische Verbindung zwischen der jeweiligen weiteren Diode und der jeweiligen weiteren Schaltung zum Speichern von elektrischen Ladungen geschaltet, so fließt die am Eingangsanschluss eingespeiste Wechselspannung über die jeweilige weitere Diode an den jeweiligen weiteren Ausgangsanschluss. Befindet sich dagegen durch einen weiteren Schaltzustand des jeweiligen weiteren ersten Schalters ein elektrisches Schwebepotenzial in der elektrischen Verbindung zwischen der jeweiligen weiteren Diode und der jeweiligen weiteren Schaltung zum Speichern von elektrischen Ladungen, so ist die jeweilige weitere Diode gesperrt.

Hinsichtlich der Bauelemente dieser vierten Erweiterung der erfindungsgemäßen Schaltung gilt das zu den äquivalenten Bauelementen der erfindungsgemäßen Grundschaltung obig Gesagte äquivalent.

Die Ansteuerung des zu jeder Diode gehörigen ersten Schalters erfolgt über eine Steuerschaltung. Die Steuerschaltung kann als Mikroprozessor ausgebildet sein oder einen Mikroprozessor umfassen. Anstelle eines Mikroprozessors kann auch eine beliebige weitere Schaltung zur Implementierung der Ansteuerfunktion vorgesehen sein, beispielsweise eine oder mehrere Anordnungen diskreter elektrischer Bauteile auf einer Leiterplatte, eine speicherprogrammierbare Steuerung (SPS), eine anwendungsspezifische integrierte Schaltung (ASIC) oder eine sonstige programmierbare Schaltung, beispielsweise auch ein Field Programmable Gate Array (FPGA), eine programmierbare logische Anordnung (PLA) und/oder ein handelsüblicher Computer.

Die Steuerschaltung, die mit jedem ersten Schalter über jeweils eine Signalübertragungsstrecke verbunden ist, schaltet jeden der ersten Schalter jeweils ein oder aus. Bevorzugt ist jeder erste Schalter jeweils zu einer unterschiedlichen Zeit eingeschaltet, sodass die am Eingangsanschluss eingespeiste Wechselspannung nur zu einem einzigen Ausgangsanschluss weiter geschaltet wird. Denkbar ist aber auch, dass die am Eingangsanschluss eingespeiste Wechselspannung über mehrere eingeschaltete erste Schalter an mehrere Ausgangsanschlüsse geschaltet werden kann.

Bevorzugt wird jeder erste Schalter von der Steuerschaltung erst dann eingeschaltet, wenn jeder der ersten Schalter ausgeschaltet ist. Auf diese Weise wird erreicht, dass der transiente Übergang von einer leitenden Diode, bevorzugt einer leitenden pin-Diode, zu einer gesperrten Diode, bevorzugt einer gesperrten pin-Diode, abgeschlossen ist und somit ein Sperrbetrieb jeder Diode gewährleistet ist.

Die Steuerschaltung berücksichtigt beim Ausschalten jedes ersten Schalters, dass die Ausschaltzeit jedes ersten Schalters jeweils mindestens solange andauert, bis ein Spannungspotential in der elektrischen Verbindung zwischen der jeweiligen Diode und der jeweiligen Schaltung zum Speichern von elektrischen Ladungen jeweils größer als eine Spannung ist, die die größte Spannung von allen in der Schaltung enthaltenen Gleichspannungsquellen jeweils erzeugten Spannungen ist. Auf diese Weise ist gewährleistet, dass sich die jeweils auszuschaltende Diode bzw. pin-Diode zu diesem Zeitpunkt sicher im Sperrbetrieb befindet.

Zusätzlich ist von der Erfindung eine gesteuerte Wechselspannungsquelle mit abgedeckt. Diese gesteuerte Wechsel Spannungsquelle umfasst eine Wechselspannungsquelle, bevorzugt eine Hochfrequenzspannungsquelle und eine erfindungsgemäße Schaltung zum Schalten einer Wechselspannung, deren Eingangsanschluss mit der Wechselspannungsquelle verbunden ist. Eine zur Schaltung zum Schalten einer Wechselspannung gehörige Steuerschaltung ist hierbei derart eingerichtet, dass sie die Wechselspannungsquelle ein- und ausschaltet.

Die Steuerschaltung übernimmt also bei einer gesteuerten Wechselspannungsquelle nicht nur das Durchschalten bzw. Sperren der Wechselspannung durch die jeweilige Diode, sondern auch das vom Durchschalten bzw. Sperren unabhängige Ein- und Ausschalten der Wechselspannungsquelle.

In einer bevorzugten Erweiterung der erfindungsgemäßen gesteuerten Wechselspannungsquelle ist die Steuerschaltung derart eingerichtet, dass sie die Wechselspannungsquelle solange eingeschaltet lässt, bis das Spannungspotential in der elektrischen Verbindung zwischen der jeweiligen Diode und der jeweiligen Schaltung zum Speichern von elektrischen Ladungen jeweils größer als eine größte Spannung von allen in der Schaltung enthaltenen Gleichspannungsquellen ist.

Auf diese Weise ist vorteilhaft gewährleistet, dass nach dem Öffnen des jeweiligen ersten Schalters die zugehörige Schaltung zum Speichern von elektrischen Ladungen nicht nur mit den elektrischen Ladungen des abklingenden Diodengleichstroms, sondern auch mit den elektrischen Ladungen des abklingenden Diodenwechselstroms aufgeladen wird. Die Schaltung zum Speichern von elektrischen Ladungen wird somit auf eine höhere Sperrspannung aufgeladen. Auf diese Weise wird entweder ein früheres Sperren der jeweiligen Diode oder ein sicheres Sperren der jeweiligen Diode erzielt.

Darüber hinaus umfasst die Erfindung eine Motoransteuerschaltung, welche eine Wechselspannung einer Wechselspannungsquelle zyklisch einer bestimmten Anzahl von elektrischen Zündkerzen zuführt. Hierzu ist die Wechselspannungsquelle mit dem Eingangsanschluss der erfindungsgemäßen Schaltung zum Schalten einer Wechselspannung und jede elektrische Zündkerze jeweils mit einem Ausgangsanschluss der erfindungsgemäßen Schaltung zum Schalten einer Wechselspannung verbunden.

Mit der erfindungsgemäßen Motoransteuerungsschaltung ist eine Schaltung geschaffen, die eine von einer einzigen Wechselspannungsquelle erzeugte Wechselspannung im zyklischen Wechsel einer Anzahl von elektrischen Zündkerzen zuschalten kann. Somit ist mit der erfindungsgemäßen Motoransteuerungsschaltung vorteilhaft eine deutliche Einsparung von Wechselspannungsquellen erzielbar.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
Fig. 1 eine Darstellung einer Schaltung zum Schalten einer Wechselspannung nach dem Stand der Technik,
Fig. 2A eine Darstellung einer Kennlinie einer pn- oder pin-Diode nach dem Stand der Technik,
Fig. 2B ein Zeitdiagramm des Wechselstroms durch eine pin-Diode im Durchlassbetrieb,
Fig. 2C ein Zeitdiagramm eines niederfrequenten Wechselstroms durch eine pn-Diode im Übergang zum Sperrbetrieb,
Fig. 2D ein Zeitdiagramm eines höherfrequenten Wechselstroms durch eine pin-Diode im Übergang zum Sperrbetrieb,
Fig. 3A eine Darstellung einer ersten Variante der erfindungsgemäßen Schaltung zum Schalten einer Wechselspannung,
Fig. 3B eine Darstellung einer zweiten Variante der erfindungsgemäßen Schaltung zum Schalten einer Wechselspannung,
Fig. 3C eine Darstellung einer dritten Variante der erfindungsgemäßen Schaltung zum Schalten einer Wechselspannung,
Fig. 3D eine Darstellung einer vierten Variante der erfindungsgemäßen Schaltung zum Schalten einer Wechselspannung,
Fig. 3E ein Zeitdiagramm des Wechselstroms in einer erfindungsgemäßen Schaltung zum Schalten einer Wechselspannung,
Fig. 4A eine Darstellung einer ersten Erweiterung der erfindungsgemäßen Schaltung zum Schalten einer Wechselspannung,
Fig. 4B ein Zeitdiagramm des Wechselstroms in einer ersten Erweiterung der erfindungsgemäßen Schaltung zum Schalten einer Wechselspannung,
Fig. 5A eine Darstellung einer zweiten Erweiterung der erfindungsgemäßen Schaltung zum Schalten einer Wechselspannung,
Fig. 5B ein Zeitdiagramm des Wechselstroms in einer zweiten Erweiterung der erfindungsgemäßen Schaltung zum Schalten einer Wechselspannung,
Fig. 6A eine Darstellung einer dritten Erweiterung der erfindungsgemäßen Schaltung zum Schalten einer Wechselspannung,
Fig. 6B ein Zeitdiagramm des Wechselstroms in einer dritten Erweiterung der erfindungsgemäßen Schaltung zum Schalten einer Wechselspannung und
Fig. 7 eine Darstellung einer vierten Erweiterung der erfindungsgemäßen Schaltung zum Schalten einer Wechselspannung.

Die beiliegenden Figuren der Zeichnung sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

Im Folgenden werden die Figuren zusammenhängend und übergreifend beschrieben.

### BESCHREIBUNG VON AUSFÜHRUNGSBEISPIELEN

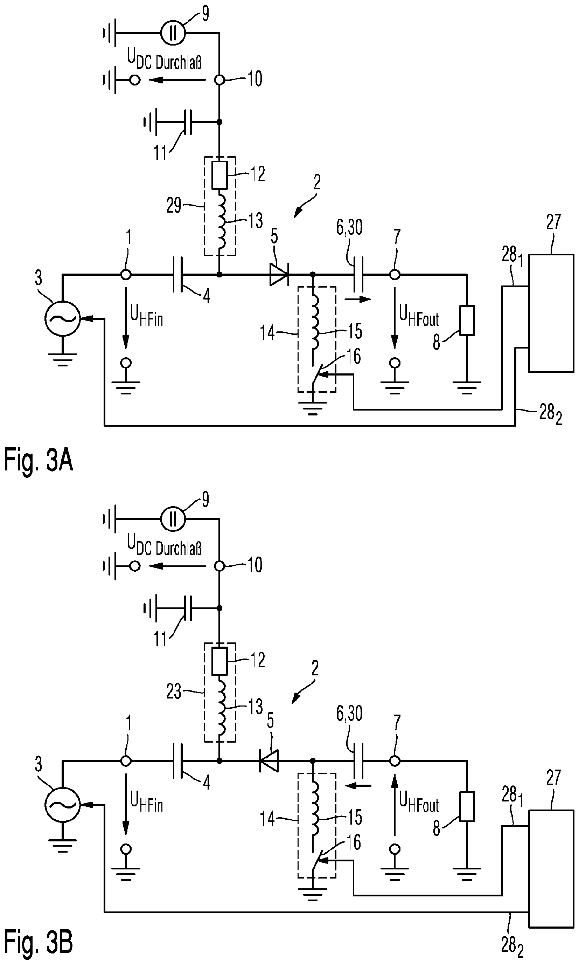

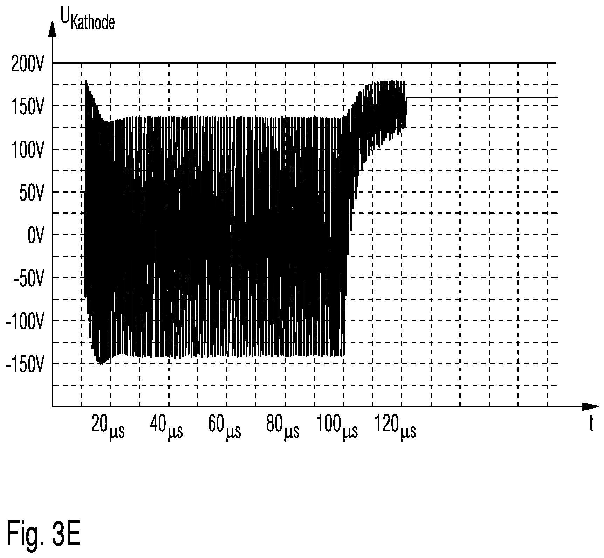

Im Folgenden werden die vier Varianten einer erfindungsgemäßen Schaltung zum Schalten einer Wechselspannung anhand der Fig. 3A bis 3D im Detail erläutert:
Am Eingangsanschluss 1 der erfindungsgemäßen Schaltung 2 zum Schalten einer Wechselspannung ist eine Wechselspannungsquelle 3 angeschlossen. Bei der Wechselspannungsquelle 3 handelt es sich bevorzugt um eine Spannungsquelle zur Erzeugung einer Hochfrequenzspannung. Dies kann beispielsweise ein Frequenzoszillator oder jede andere Hochfrequenzschaltung sein, die eine Hochfrequenzspannung mit einer bestimmten einstellbaren oder fixen Frequenz und einer bestimmten einstellbaren oder fixen Amplitude erzeugt.

Diese Wechselspannungsquelle 3 bzw. Spannungsquelle zur Erzeugung einer Hochfrequenzspannung prägt eine bestimmte Wechselspannung bzw. Hochfrequenzspannung in die erfindungsgemäße Schaltung 2 zum Schalten einer Wechselspannung ein. Alternativ sind auch eine Wechselstromquelle bzw. eine Stromquelle zur Erzeugung eines hochfrequenten Stroms mit einem parallel geschalteten Widerstand denkbar, womit ebenfalls eine Wechselspannung bzw. eine Hochfrequenzspannung in die erfindungsgemäße Schaltung einprägbar ist.

Der Eingangsanschluss 1 ist mit einem eingangsseitigen Koppelkondensator 4 verbunden, über den einzig eine Wechselspannung, bevorzugt die Hochfrequenzspannung U_{HFin}, in die erfindungsgemäße Schaltung 2 einkoppelbar ist. Der eingangsseitige Koppelkondensator 4 verhindert ebenso ein Auskoppeln einer Gleichspannung aus der erfindungsgemäßen Schaltung 2 in Richtung der Wechselspannungsquelle 3.

Der eingangsseitige Koppelkondensator 4 ist in der ersten Variante der erfindungsgemäßen Schaltung mit der Anode der Diode 5, die bevorzugt eine pin-Diode 5 ist, verbunden. Die Kathode der Diode 5 ist mit einem ausgangsseitigen Koppelkondensator 6 verbunden. Der ausgangsseitige Koppelkondensator 6 stellt in der ersten Variante der erfindungsgemäßen Schaltung den Kondensator 30 dar, der als Schaltung zum Speichern von elektrischen Ladungen dient. Die Serienschaltung umfassend die Diode 5 und die Schaltung zum Speichern von elektrischen Ladungen wird im Folgenden als erste Serienschaltung bezeichnet. Der ausgangsseitige Koppelkondensator 6, d.h. der als Schaltung zum Speichern von elektrischen Ladungen dienende Kondensator 30, ist schließlich mit dem (Wechselspannungs-)Ausgangsanschluss 7 der erfindungsgemäßen Schaltung 2 verbunden. Der ausganzseitige Koppelkondensator 6 koppelt lediglich eine Wechselspannung bzw. eine Hochfrequenzspannung aus der erfindungsgemäßen Schaltung 2 aus und blockt eine Gleichspannung ab. Über den ausgangsseitigen Koppelkondensator 6 ist ebenso auch keine Gleichspannung in die erfindungsgemäße Schaltung 2 einkoppelbar.

Die am Ausgangsanschluss 7 der erfindungsgemäßen Schaltung 2 anliegende Wechselspannung bzw. Hochfrequenzspannung U_{HFout} ist mit einem Anschluss einer Lastimpedanz 8 verbunden. Der andere Anschluss der Lastimpedanz 8 ist typischerweise auf ein Massepotenzial geführt. Die Lastimpedanz 8 kann eine beliebige komplexwertige Impedanz sein. Für eine Anwendung der erfindungsgemäßen Schaltung 2 zum Schalten einer Wechselspannung im Automobilbereich ist die Last beispielsweise eine mit der erfindungsgemäßen Schaltung 2 verbundene elektrische Zündkerze. Die Lastimpedanz 8 setzt sich in diesem Fall mindestens aus der Leitungsimpedanz der (Hochfrequenz-)Zuleitung zur Zündkerze, der Impedanz des Innenleiters der Zündkerze, parasitären Kapazitäten und der Impedanz der im Verbrennungsraum zwischen den Zündkerzenelektroden jeweils herrschenden Impedanz zusammen.

Zum Durchschalten der am Eingangsanschluss 1 anliegenden Wechselspannung bzw. Hochfrequenzspannung an den Ausgangsanschluss 7 über die Diode 5, die bevorzugt eine pin-Diode 5 ist, ist ein ausreichender Diodengleichstrom I_{DCDurchlaß} in Durchlassrichtung der Diode 5 erforderlich. In diesem Fall wird die Wechselspannung bzw. Hochfrequenzspannung U_{HFin} am Eingang in eine Wechselspannung bzw. Hochfrequenzspannung U_{HFout} am Ausgang der erfindungsgemäßen Schaltung 2 geschaltet.

Dieser Diodengleichstrom I_{DCDurchlaß} wird bevorzugt in einer Gleichspannungsquelle 9 erzeugt. Diese Gleichspannungsquelle 9 erzeugt an einem weiteren Eingangsanschluss 10 der erfindungsgemäßen Schaltung 2, einem Gleichspannungseingangsanschluss, eine Gleichspannung U_{DCDurchlaß}. Der weitere Eingangsanschluss 10 ist mit dem Anschluss eines Querkondensators 11 verbunden, dessen weiterer Anschluss an das Massepotenzial geführt ist. Der Querkondensator 11 ist als Stabilisierungskondensator geschaltet und filtert am weiteren Anschluss 10 auftretende nieder- oder höherfrequente Störsignale aus der von der Gleichspannungsquelle 9 erzeugten Gleichspannung U_{DCDurchlaß} heraus.

Zur Erzeugung eines Diodengleichstroms I_{DCDurchlaß} ist der weitere Eingangsanschluss 10 mit einem Widerstand 12 verbunden. Der Widerstand 12 ist derart dimensioniert, dass bei einer von der Gleichspannungsquelle 9 erzeugten Gleichspannung U_{DCDurchlaß} der erforderliche Diodengleichstrom I_{DCDurchlaß} durch den Widerstand 12 fließt. Neben der Erzeugung des Diodengleichstrom I_{DCDurchlaß} in einer Gleichspannungsquelle 9 und einem nachgeschalteten Wiederstand 12 kann der Diodengleichstrom I_{DCDurchlaß} alternativ auch in einer Gleichstromquelle erzeugt werden.

In der ersten Variante der erfindungsgemäßen Schaltung wird der Diodengleichstrom I_{DCDurchlaß} in die Diode 5 eingeprägt, indem die Gleichspannungsquelle 5 an die elektrische Verbindung zwischen dem Eingangsanschluss 1 und der Anode Diode 5 angeschlossen ist. Der Anschluss der Gleichspannungsquelle 9 an die elektrische Verbindung zwischen dem Eingangsanschluss 1 und der Anode der Diode 5 erfolgt über den Widerstand 12 und die nachgeschaltete erste Spule 13. Alternativ können der Widerstand 12 und die erste Spule 13 innerhalb der Serienschaltung 29 in ihrer Reihenfolge auch vertauscht sein. Diese erste Spule 13 ermöglicht eine niederohmige Einspeisung des Diodengleichstroms I_{DCDurchlaß} in die Diode 5. Außerdem verhindert die erste Spule 13 ein Auskoppeln der Wechselspannung, bevorzugt der Hochfrequenzspannung, aus der erfindungsgemäßen Schaltung 2 in Richtung der Gleichspannungsquelle 9.

Alternativ kann anstelle der ersten Spule jede beliebige Schaltung mit einer Tiefpassfiltercharakteristik oder eine Schaltung mit einem Widerstand, der bei höheren Frequenzen eine gewisse Induktivität aufweist, beispielsweise ein Bonddraht oder eine als Butterfly-Stub realisierte Streifenleitung, benutzt werden.

Um einen Stromfluss für den Diodengleichstrom I_{DCDurchlaß} von der Gleichspannungsquelle 9 durch die Diode 5 bis zu einem Bezugspotenzial zu ermöglichen, ist die elektrische Verbindung zwischen der Diode 5 und dem als Schaltung zum Speichern von elektrischen Ladungen dienenden Kondensator 30 eine elektrische Verbindung zum Bezugspotenzial zu realisieren. Das Bezugspotential ist in Fig. 3A beispielsweise das Massepotential der Schaltung. Hierzu ist zwischen dem Massepotenzial und der elektrischen Verbindung zwischen der Diode 5 und dem Kondensator 30 eine Serienschaltung 14 umfassend eine zweite Spule 13 und einen ersten Schalter 16 geschaltet. Hierbei kann, wie in Fig. 3A dargestellt ist, die zweite Spule 13 mit der Kathode der Diode 5 und der erste Schalter 16 mit dem Massepotenzial verbunden sein. Alternativ ist auch eine elektrische Verbindung des ersten Schalters 16 mit der Kathode der Diode 5 und der zweiten Spule 13 mit dem Massepotenzial möglich.

Die zweite Spule 13 ermöglicht wiederum eine niederohmige Auskopplung des Diodengleichstroms I_{DCDurchlaß} aus der erfindungsgemäßen Schaltung 2 in Richtung des Massepotenzials. Außerdem verhindert die zweite Spule 13 ein Kurzschließen der Wechselspannung bzw. der Hochfrequenzspannung von der Kathode der Diode 5 zum Massepotenzial.

Der erste Schalter 16 wird über eine Signalübertragungsstrecke 28₁ durch eine Steuerschaltung 27 angesteuert. Die Signalübertragungsstrecke 28₁ kann entweder leitungsgebunden oder funkgestützt realisiert sein. Im Durchlassbetrieb der Diode 5 bzw. der pin-Diode 5 ist der erste Schalter 16 geschlossen, während er im Sperrbetrieb geöffnet ist.

Bei geschlossenen ersten Schalter 16 im Durchlassbetrieb der Diode 5 bzw. der pin-Diode 5 ergibt sich ein Diodenstrom, der sich gemäß Fig. 2B aus der Überlagerung des Diodengleichstroms I_{DCDurchlaß} und des von der Wechselspannung bzw. der Hochfrequenzspannung U_{HFin} eingeprägten Diodenwechselstroms I_{HF} ergibt. In diesem Fall liegt in der elektrischen Verbindung zwischen der Diode 5 und dem Kondensator 30 ein Potenzial, das vom Bezugspotenzial bzw. Massepotenzial abhängig ist.

Bei geöffnetem ersten Schalter 16 und im Fall eines verzögerten Ausschaltens des Diodenwechselstroms - sogenanntes "Nachbrennen" der Wechselspannung bzw. der Hochfrequenzspannung - ergibt sich im Übergang zwischen dem Durchlass- und dem Sperrbetrieb bei einer niedrigeren Frequenz des eingespeisten Wechselstroms gemäß Fig. 2C ein Gesamtdiodenstrom, der mit einer Zeitkonstante abklingt und gleichzeitig Lücken im Stromfluss aufweist.

Bei einer höheren Frequenz des eingespeisten Wechselstroms ergibt sich im Übergang zwischen dem Durchlass- und dem Sperrbetrieb gemäß Fig. 2D ein Gesamtdiodenstrom, der ohne Lücken im Stromfluss mit einer Zeitkonstante abklingt.

Die "Nachbrenndauer" der Wechselspannung bzw. der Hochfrequenzspannung ist an die Zeitkonstante des Abklingens des Gesamtdiodenstroms geeignet anzupassen. Wird die Wechselspannung bzw. die Hochfrequenzspannung ohne "Nachbrenndauer" und damit gleichzeitig mit der Gleichspannung ausgeschaltet, so ergibt sich als Abklingen des Diodenstroms einzig der in den Figuren 2C und 2D jeweils gestrichelt dargestellte Verlauf des Diodengleichstroms. In Abhängigkeit der Parameter der Diode 5 bzw. der pin-Diode 5 ist der Diodengleichstrom u.U. zu gering, um den ersten Kondensator 6 auf ein ausreichendes Kondensatorspannungsniveau zur Sperrung der Diode 5 aufzuladen. In diesem Fall ist eine ausreichende "Nachbrenndauer" der Wechselspannung bzw. der Hochfrequenzspannung für ein Sperren der Diode 5 erforderlich.

Die Zeitkonstante des Abklingens des Diodenstroms ist im Wesentlichen vom Durchlasswiderstand der Diode 5 und der Kapazität des Kondensators 30 abhängig. Durch Wahl der entsprechenden Diode 5 bzw. der pin-Diode 5 und damit des Durchlasswiderstandes der Diode 5 und der Kapazität des Kondensators 30 kann die Zeitkonstante geeignet dimensioniert werden. Hierbei ist zu beachten, dass durch die Wahl der Kapazität für den Kondensator 30 bei gegebener Diodenstromhöhe, d.h. transportierter Ladungsträgermenge, zum Kondensator 30 die erzielbare Sperrspannung für die Diode 5 bestimmt ist. Somit ist durch eine geeignete Parameterwahl ein sinnvoller Kompromiss zwischen einem möglichst schnellen Sperren und einem möglichst sicheren Sperren zu wählen.

Die Steuerschaltung 27 kann den ersten Schalter 16 frühestmöglich wieder einschalten, wenn der transiente Vorgang vom Durchlassbetrieb zum Sperrbetrieb der Diode 5 sicher abgeschlossen ist. Dies ist der Fall, wenn das Spannungspotenzial in der elektrischen Verbindung zwischen der Diode 5 und dem Kondensator 30, der die Schaltung zum Speichern von elektrischen Ladungen darstellt, größer als die von der Spannungsquelle 9 erzeugte Gleichspannung U_{DCDurchlaß} ist. In diesem Fall liegt an der Kathode der Diode 5 ein ausreichendes Sperrpotenzial an. Sind in der Schaltung zum Schalten einer Wechselspannung mehrere Gleichspannungsquellen integriert, die ein Sperren der Diode 5 beeinflussen können, so ist der erste Schalter 16 von der Steuerschaltung 27 erst dann frühestmöglich wieder einschaltbar, wenn das Spannungspotenzial in der elektrischen Verbindung zwischen der Diode 5 und dem Kondensator 30 größer als die größte Spannung von allen Spannungen ist, die jeweils von allen in der Schaltung realisierten Gleichspannungsquellen erzeugt werden.

Die Steuerschaltung 27 schaltet über die Signalübertragungsstrecke 28₂ die Wechselspannungsquelle 3 ein- und aus. Die Steuerschaltung 27 schaltet insbesondere die Wechselspannungsquelle 3 gegenüber dem Öffnen des ersten Schalters 16 verzögert aus. Dieses "Nachbrennen" der Wechselspannung wird spätestens über die Steuerschaltung 27 durch Ausschalten der Wechselspannungsquelle 3 beendet, wenn das Spannungspotenzial in der elektrischen Verbindung zwischen der Diode 5 und dem Kondensator 30 größer als die größte von allen erzeugten Gleichspannungen der in der Schaltung realisierten Gleichspannungsquellen ist.

Zusammenfassend lässt sich also sagen, dass in der ersten Variante im Durchlassbetrieb der Diode 5 ein Stromfluss bzw. ein DC-Stromflusspfad von der Spannungsquelle 9 über die Diode 5 zuzüglich externer Beschaltungselemente bis zum Massepotenzial bzw. Bezugspotenzial ergibt, das mit dem ersten Schalter 16 elektrisch verbunden ist. Nach dem Öffnen des ersten Schalters 16 lädt sich der Kondensator 30 über die in der transienten Phase fließenden elektrischen Ladungen auf eine Kondensatorspannung auf, deren Polarität in Fig. 3A dargestellt ist und die Diode 5 in den Sperrbetrieb überführt.

In einer zweiten Variante der erfindungsgemäßen Schaltung zum Schalten einer Wechselspannung gemäß Fig. 3B ist die Gleichspannungsquelle 9 zur Einprägung eines Gleichstroms in die Diode 5 ebenfalls wie in der ersten Variante an die elektrische Verbindung zwischen dem Eingangsanschluss 1 und der Diode 5 angeschlossen. Die Diode 5, die bevorzugt als pin-Diode 5 ausgeführt ist, ist in der zweiten Variante gegenüber der ersten Variante umgekehrt gepolt. Hierbei ist die Kathode der Diode 5 über eine elektrische Verbindung mit dem Eingangsanschluss 1 und die Anode über eine elektrische Verbindung mit dem Ausgangsanschluss 7 elektrisch verbunden. Somit ist die Gleichspannungsquelle 9 mit der Kathode der Diode 5 elektrisch verbunden. Außerdem ist die Gleichspannungsquelle 9 in der zweiten Variante gegenüber der Gleichspannungsquelle 9 in der ersten Variante umgekehrt gepolt. Somit fällt die von der Gleichspannungsquelle 9 erzeugte Gleichspannung U_{DCDurchlaß} vom Massepotenzial zum weiteren Eingangsanschluss 10 ab.

Somit ergibt sich in der zweiten Variante im Durchlassbetrieb der Diode 5 ein Stromfluss bzw. ein DC-Stromflusspfad vom Massepotenzial bzw. Bezugspotenzial, das mit dem ersten Schalter 16 elektrisch verbunden ist, über die Diode 5 zuzüglich externer Beschaltungselemente bis zur Gleichspannungsquelle 9. Nach Öffnen des ersten Schalters 16 lädt sich der Kondensator 30 über die in der transienten Phase fließenden elektrischen Ladungen auf eine Kondensatorspannung auf, deren Polarität in Fig. 3B dargestellt ist und die Diode 5 in den Sperrbetrieb überführt.

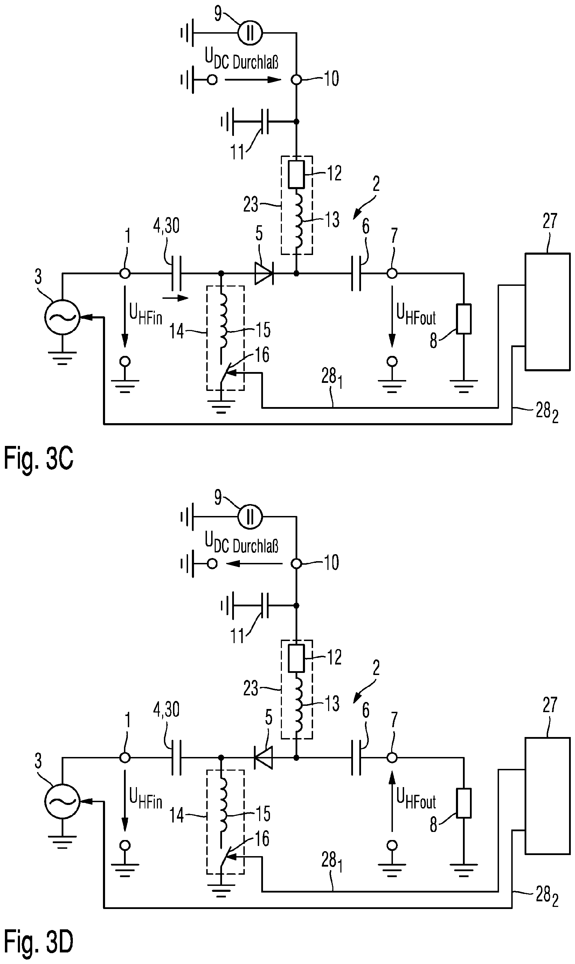

In einer dritten Variante der erfindungsgemäßen Schaltung zum Schalten einer Wechselspannung gemäß Fig. 3C ist die Gleichspannungsquelle 9 zur Einprägung eines Gleichstroms in die Diode 5 an die elektrische Verbindung zwischen dem Ausgangsanschluss 7 und der Diode 5 angeschlossen. In der dritten Variante ist die Anode der Diode 5 über eine elektrische Verbindung mit dem Eingangsanschluss 1 und die Kathode über eine elektrische Verbindung mit dem Ausgangsanschluss 7 elektrisch verbunden. Somit ist die Gleichspannungsquelle 9 mit der Kathode der Diode 5 elektrisch verbunden. Außerdem ist der erste Schalter 16 mit oder ohne Zwischenschaltung einer Schaltung mit Tiefpassfiltercharakteristik oder einer Schaltung mit einem Widerstand an die elektrische Verbindung zwischen der Anode der Diode 5 und dem eingangsseitigen Koppelkondensator 4 angeschlossen. Dieser eingangsseitige Koppelkondensator 4 dient in der dritten Variante als Kondensator 30 zur Realisierung der Schaltung zur Speicherung von elektrischen Ladungen. Die Gleichspannungsquelle 9 ist so gepolt, dass die von ihr generierte Gleichspannung U_{DCDurchlaß} vom Massepotenzial zum weiteren Eingangsanschluss 10 gerichtet ist.

Somit ergibt sich in der dritten Variante im Durchlassbetrieb der Diode 5 ein Stromfluss bzw. ein DC-Stromflusspfad vom Massepotenzial bzw. Bezugspotenzial, das mit dem ersten Schalter 16 elektrisch verbunden ist, über die Diode 5 zuzüglich externer Beschaltungselemente bis zur Gleichspannungsquelle 9. Nach Öffnen des ersten Schalters 16 lädt sich der eingangsseitige Koppelkondensator 4, der als Kondensator 30 zur Realisierung der Schaltung zum Speichern von elektrischen Ladungen dient, über die in der transienten Phase fließenden elektrischen Ladungen auf eine Kondensatorspannung auf. Die Polarität der Kondensatorspannung ist in Fig. 3C dargestellt und führt die Diode 5 in den Sperrbetrieb über.

In einer vierten Variante der erfindungsgemäßen Schaltung zum Schalten einer Wechselspannung gemäß Fig. 3D ist die Gleichspannungsquelle 9 zur Einprägung eines Gleichstroms in die Diode 5 ebenfalls wie in der dritten Variante an die elektrische Verbindung zwischen der Diode 5 und dem Ausgangsanschluss 7 angeschlossen. Die Diode 5, die bevorzugt als pin-Diode 5 ausgeführt ist, ist in der vierten Variante gegenüber der dritten Variante umgekehrt gepolt. In der vierten Variante ist die Kathode der Diode 5 über eine elektrische Verbindung mit dem Eingangsanschluss 1 und die Anode über eine elektrische Verbindung mit dem Ausgangsanschluss 7 elektrisch verbunden. Somit ist die Gleichspannungsquelle 9 mit der Anode der Diode 5 elektrisch verbunden. Außerdem ist die Gleichspannungsquelle 9 in der vierten Variante gegenüber der Gleichspannungsquelle 9 in der dritten Variante umgekehrt gepolt. Somit fällt die von der Gleichspannungsquelle 9 erzeugte Gleichspannung U_{DCDurchlaß} vom weiteren Eingangsanschluss 10 zum Massepotenzial ab. Der erste Schalter 16 ist in der vierten Variante mit oder ohne Zwischenschaltung einer Schaltung mit Tiefpassfiltercharakteristik oder einer Schaltung mit einem Widerstand an die elektrische Verbindung zwischen der Kathode der Diode 5 und dem eingangsseitigen Koppelkondensator 4 angeschlossen. Dieser eingangsseitige Koppelkondensator 4 dient in der vierten Variante als Kondensator 30 zur Realisierung der Schaltung zur Speicherung von elektrischen Ladungen.

Somit ergibt sich in der vierten Variante im Durchlassbetrieb der Diode 5 ein Stromfluss bzw. ein DC-Stromflusspfad von der Gleichspannungsquelle 9 über die Diode 5 zuzüglich externer Beschaltungselemente bis zum Massepotenzial bzw. Bezugspotenzial, das mit dem ersten Schalter 16 elektrisch verbunden ist. Nach dem Öffnen des ersten Schalters 16 lädt sich der Kondensator 30 über die in der transienten Phase fließenden elektrischen Ladungen auf eine Kondensatorspannung auf, deren Polarität in Fig. 3D dargestellt ist und die Diode 5 in den Sperrbetrieb überführt.

Im Zeitdiagramm der Fig. 3D ist beispielhaft für die erste Variante der erfindungsgemäßen Schaltung die Spannung an der Kathode der Diode 5 gegen Massepotenzial dargestellt. Hierbei wird zum Zeitpunkt t=10 µsec gleichzeitig eine Gleichspannung von 12 V und eine Wechselspannung mit einer Amplitude in Höhe von 150 V eingeschaltet. Bei durchgeschalteter Diode 5 liegt an der Kathode der Diode 5 eine Gleichspannung von ca. 0,3 V an, der eine Wechselspannung mit einer Amplitude von ca. 150 V überlagert ist. Zum Zeitpunkt t=100 µsec wird der DC-Durchlass-Pfad geöffnet, während die Wechselspannung noch bis zum Zeitpunkt t=120 µsec eingeschaltet bleibt. Nach dem Öffnen des DC-Durchlass-Pfades findet bei noch eingeschalteter Wechselspannung ein Aufladen des ersten Kondensators 6 auf eine Spannung von ca. 160 V statt, die als Sperrspannung zum endgültigen Sperren der Diode 5 dient.

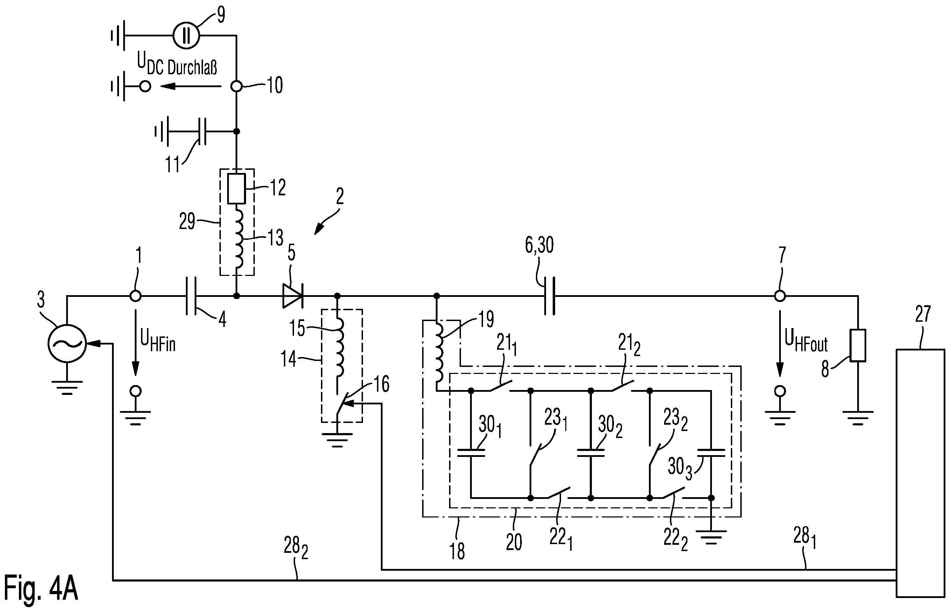

Aus Fig. 4A geht eine erste Erweiterung der erfindungsgemäßen Schaltung 2 zum Schalten einer Wechselspannung hervor:
In der ersten Erweiterung der erfindungsgemäßen Schaltung 2 ist zwischen der elektrischen Verbindung, die die Kathode der Diode 5, bevorzugt einer pin-Diode 5, mit dem Kondensator 6 verbindet, und einem Massepotenzial eine Serienschaltung 18 umfassend eine dritte Spule 19 und eine Verschaltung 20 von weiteren Kondensatoren 30₁, 30₂ und 30₃ geschaltet. Die Serienschaltung umfassend eine dritte Spule 19 und eine Verschaltung 20 von weiteren Kondensatoren 30₁, 30₂ und 30₃ wird im Folgenden als zweite Serienschaltung bezeichnet. Hierbei kann die dritte Spule 19, wie in Fig. 4A dargestellt ist, mit der Kathode der Diode 5 und dem Kondensator 6 verbunden sein, während die Verschaltung 20 von weiteren Kondensatoren 30₁, 30₂ und 30₃ an das Massepotenzial geführt ist. Alternativ kann die Verschaltung 20 von weiteren Kondensatoren 30₁, 30₂ und 30₃ mit der Kathode der Diode 5 und dem ersten Kondensator 6 verbunden sein, während die dritte Spule 19 an das Massepotenzial geführt ist.

Die dritte Spule 19 verhindert ein Kurzschließen der Wechselspannung von der Kathode der Diode 5 über die Verschaltung 20 von weiteren Kondensatoren 30₁, 30₂ und 30₃ auf das Massepotenzial. Außerdem ermöglicht die dritte Spule 19 ein niederohmiges Aufladen der weiteren Kondensatoren 30₁, 30₂ und 30₃ durch den Diodengleichstrom.

Der Kondensator 30, der durch den ausgangsseitigen Koppelkondensator 6 gebildet wird, und die weiteren Kondensatoren 30₁, 30₂ und 30₃ bilden eine Schaltung zum Speichern von elektrischen Ladungen.

Die weiteren Kondensatoren 30₁, 30₂ und 30₃ sind in einer Parallelverschaltung oder alternativ in einer Serienverschaltung verschaltbar. Zur Realisierung der Parallelverschaltung der weiteren Kondensatoren 30₁, 30₂ und 30₃ sind zwischen den Anschlüssen der weiteren Kondensatoren 30₁, 30₂ und 30₃ kathodenseitig, d.h. in der elektrischen Verbindung zur Kathode der Diode 5, jeweils ein zweiter Schalter 21₁ und 21₂ und zwischen den Anschlüssen der weiteren Kondensatoren 30₁, 30₂ und 30₃ auf der Seite des Massepotenzials, d.h. in der elektrischen Verbindung zum Massepotential, jeweils ein dritter Schalter 22₁ und 22₂ vorgesehen. In der Parallelverschaltung der weiteren Kondensatoren 30₁, 30₂ und 30₃ sind die einzelnen zweiten Schalter 21₁ und 21₂ und die einzelnen dritten Schalter 22₁ und 22₂ durch Ansteuerung über die Steuerschaltung 27 geschlossen.

Zwischen zwei Anschlüssen von zwei weiteren Kondensatoren 30₁, 30₂ und 30₃ ist jeweils ein vierter Schalter 23₁ und 23₂ geschaltet. Diese vierten Schalter 23₁ und 23₂ sind in der Parallelverschaltung der weiteren Kondensatoren 30₁, 30₂ und 30₃ jeweils geöffnet, während sie in der Serienverschaltung der weiteren Kondensatoren 30₁, 30₂ und 30₃ jeweils geschlossen sind. In der Serienverschaltung der weiteren Kondensatoren 30₁, 30₂ und 30₃ sind die einzelnen zweiten Schalter 21₁ und 21₂ und die einzelnen dritten Schalter 22₁ und 22₂ jeweils geöffnet. Die Ansteuerung der zweiten Schalter 21₁ und 21₂, der dritten Schalter 22₁ und 22₂ und der vierten Schalter 23₁ und 23₂ erfolgt über die Steuerschaltung 27 mittels zugehöriger Signalübertragungsstrecken, die in Fig. 4A der Übersichtlichkeit wegen nicht eingezeichnet sind.

Die Anzahl der weiteren Kondensatoren 30₁, 30₂ und 30₃ ist nicht, wie in Fig. 4A dargestellt ist, auf drei Kondensatoren festgesetzt. Vielmehr ist jede andere und technisch sinnvolle Anzahl von weiteren Kondensatoren 30₁, 30₂ und 30₃ möglich.

Im Durchlassbetrieb der Diode 5 bzw. der pin-Diode 5 sind sämtliche zweite Schalter 21₁ und 21₂, sämtliche dritte Schalter 22₁ und 22₂ und sämtliche vierte Schalter 23₁ und 23₂ jeweils geöffnet. Somit ist die Verschaltung 20 von weiteren Kondensatoren 30₁, 30₂ und 30₃ von der Kathode der Diode 5 entkoppelt. Somit liegt an der Kathode der Diode 5 ab dem Zeitpunkt t=10 µsec eine Wechselspannung mit einer Amplitude in Höhe von ca. 150 V gegen Massepotenzial an.

Nach dem Öffnen des DC-Durchlass-Pfades zum Zeitpunkt t=100 µsec sind die weiteren Kondensatoren 30₁, 30₂ und 30₃ jeweils zueinander parallelgeschaltet und damit über die dritte Spule 19 auch zum Kondensator 30 parallelgeschaltet. Der Kondensator 30 und die weiteren Kondensatoren 30₁, 30₂ und 30₃ werden somit jeweils auf eine gleiche Kondensatorspannung aufgeladen. Durch die Parallelschaltung der einzelnen Kondensatoren erfolgt dieser Ladevorgang in der ersten Erweiterung der erfindungsgemäßen Schaltung 2 gemäß Fig. 4A mit einer höheren Zeitkonstante als in der erfindungsgemäßen Grundschaltung 2 gemäß der Fig. 3A. Somit erreicht jede Kondensatorspannung und damit auch die Kathodenspannung der Diode 5 nach diesem Ladevorgang zum Zeitpunkt t=120 psec, in dem auch dann die Wechselspannung ausgeschaltet wird, einen Gleichspannungswert in Höhe von ca. 160 V.

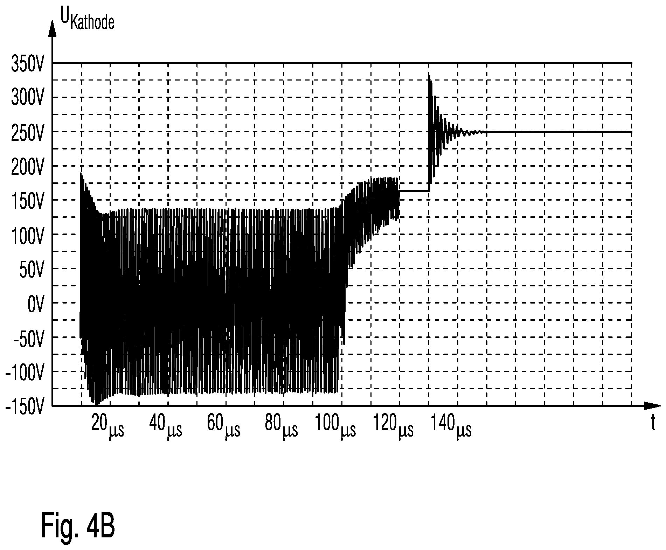

Zum Zeitpunkt t=130 µsec erfolgt eine Umschaltung zwischen der Parallelverschaltung und der Serienverschaltung der weiteren Kondensatoren 30₁, 30₂ und 30₃. Auf diese Weise erhöht sich die Kondensatorspannung über alle drei seriell verschalteten weiteren Kondensatoren 30₁, 30₂ und 30₃ auf den dreifachen Wert in Höhe von ca. 480 V. Da der parallel geschaltete Kondensator 30 weiterhin eine Kondensatorspannung in Höhe von 160 V aufweist, kommt es zwischen dem Kondensator 30 und den weiteren Kondensatoren 30₁, 30₂ und 30₃ zu einem Ausgleichsvorgang. Dieser Ausgleichsvorgang, der in Fig. 4B wegen der Serienschaltung aus der dritten Spule 19 und dem Kondensator 30 durch einen Einschwingvorgang zwischen den beiden Zeitpunkten t=130 µsec und t=150 µsec erkennbar ist, führt zu einer ausgeglichenen Kondensatorspannung des Kondensators 30 und der seriell verschalteten weiteren Kondensatoren 30₁, 30₂ und 30₃. Diese ausgeglichene Kondensatorspannung, die zur Sperrung der Diode 5 dient, beträgt ca. 250 V, wie aus Fig. 4B zu entnehmen ist. Dieser Sperrspannungswert ist somit gegenüber dem in der erfindungsgemäßen Grundschaltung vorteilhaft erhöht.

Über die Dimensionierung der Kapazität der weiteren Kondensatoren 30₁, 30₂ und 30₃, die bevorzugt jeweils gleich hoch ist, in Relation zur Kapazität des Kondensators 30 ist das Niveau der erzielbaren Sperrspannung einstellbar. Da die Kapazitäten aber auch die Zeitkonstante des Ladevorgangs beeinflussen, ist hierbei ein sinnvoller Kompromiss zwischen einer sicheren Sperrung und einer möglichst schellen Sperrung zu wählen.

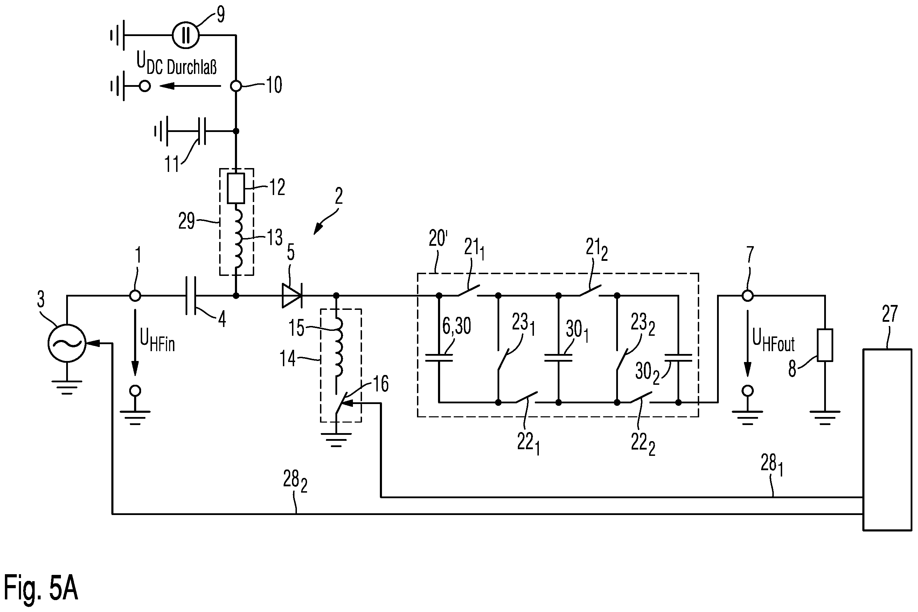

In Fig. 5A ist eine zweite und bevorzugte Erweiterung der erfindungsgemäßen Schaltung 2 zum Schalten einer Wechselspannung dargestellt:
Zwischen der Kathode der Diode 5 bzw. der pin-Diode 5 und dem Ausgangsanschluss 7 der erfindungsgemäßen Schaltung 2 ist eine Verschaltung 20' aus einem Kondensator 30, der mit dem ausgangsseitigen Koppelkondensator 6 gebildet wird, und weiteren Kondensatoren 30₁ und 30₂ geschaltet. Der aus dem ausgangsseitigen Koppelkondensator 6 gebildete Kondensator 30 und die weiteren Kondensatoren 30₁ und 30₂ bilden die Schaltung zum Speichern von elektrischen Ladungen.

In einer Parallelanordnung ist der Kondensator 30 parallel zu den weiteren Kondensatoren 30₁ und 30₂ schaltbar. Hierzu ist zwischen den kathodenseitigen Anschlüssen des Kondensators 30 und der weiteren Kondensatoren 30₁ und 30₂ jeweils ein zweiter Schalter 21₁ und 21₂ und zwischen den Anschlüssen des Kondensators 30 und der weiteren Kondensatoren 30₁ und 30₂ auf der Seite des Ausgangsanschlusses 7 jeweils ein dritter Schalter 22₁ und 22₂ geschaltet. Hierbei sind die kathodenseitigen Anschlüsse jeweils die Anschlüsse in der elektrischen Verbindung zur Kathode der Diode 5 und die Anschlüsse auf der Seite des Ausgangsanschlusses 7 jeweils die Anschlüsse in der elektrischen Verbindung zum Ausgangsanschluss 7. Zwischen den Anschlüssen des Kondensators 30 und der weiteren Kondensatoren 30₁ und 30₂ ist jeweils ein vierter Schalter 23₁ und 23₂ geschaltet. In der Parallelverschaltung des Kondensators 30 und der weiteren Kondensatoren 30₁ und 30₂ sind die zweiten Schalter 21₁ und 21₂ und die dritten Schalter 22₁ und 22₂ mittels Ansteuerung durch die Steuerschaltung 27 geschlossen. Die vierten Schalter 23₁ und 23₂ sind in der Parallelverschaltung jeweils geöffnet.

In der Serienverschaltung des Kondensators 30 und der weiteren Kondensatoren 30₁ und 30₂ sind die vierten Schalter 23₁ und 23₂ jeweils geschlossen, während die zweiten Schalter 21₁ und 21₂ und die dritten Schalter 22₁ und 22₂ jeweils geöffnet sind.

Die Ansteuerung der zweiten Schalter 21₁ und 21₂, der dritten Schalter 22₁ und 22₂ und der vierten Schalter 23₁ und 23₂ erfolgt ebenfalls über die Steuerschaltung 27 mittels zugehöriger Signalübertragungsstrecken, die in Fig. 5A der Übersichtlichkeit wegen nicht eingezeichnet sind.

Die Anzahl der weiteren Kondensatoren 30₁ und 30₂ ist nicht, wie in Fig. 4A dargestellt ist, auf zwei Kondensatoren festgesetzt. Vielmehr ist jede andere und technisch sinnvolle Anzahl von weiteren Kondensatoren 30₁ und 30₂ möglich.

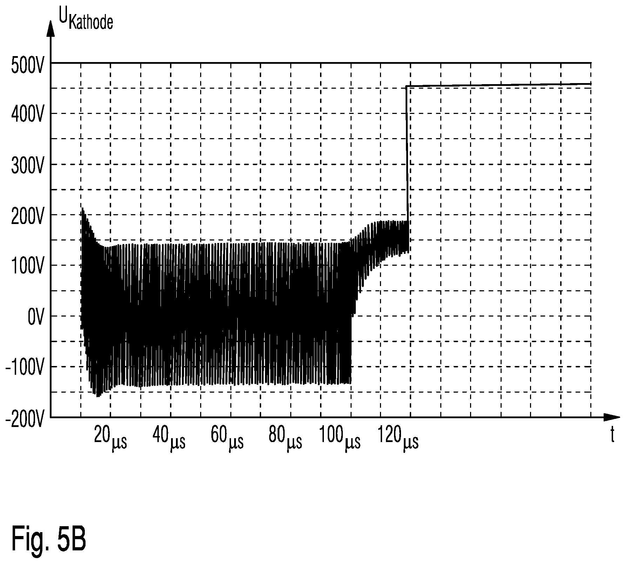

Wie aus dem Zeitverlauf der Kathodenspannung der Diode 5 gegen Massepotenzial in Fig. 5B hervorgeht, liegt im Durchlassbetrieb der Diode 5 bzw. der pin-Diode 5 an der Kathode der Diode 5 ab dem Zeitpunkt t=10 µsec eine Wechselspannung mit einer Amplitude in Höhe von 150 V gegen Massepotenzial an.

Mit dem Ausschalten der Gleichspannung bei weiterhin eingeschalteter Wechselspannung zum Zeitpunkt t=100 µsec werden der Kondensator 30 und parallel die jeweils parallel geschalteten weiteren Kondensatoren 30₁ und 30₂ aufgeladen. Aufgrund der Parallelschaltung des Kondensators 30 und der weiteren Kondensatoren 30₁ und 30₂ erfolgt das Aufladen mit einer höheren Zeitkonstante. Die höhere Zeitkonstante führt dazu, dass der Kondensator 30 und die weiteren Kondensatoren 30₁ und 30₂ zum Zeitpunkt t=120 psec, dem Ende des Ladevorgangs, jeweils auf eine Kondensatorspannung aufgeladen werden, die kleiner als die Kondensatorspannung des Kondensators 30 der erfindungsgemäßen Grundschaltung 2 zum selben Zeitpunkt ist. Die Kathodenspannung der Diode 5 zum Zeitpunkt t=120 µsec beträgt in der zweiten Erweiterung der erfindungsgemäßen Schaltung gemäß Fig. 5B ca. 150 V, während die Kathodenspannung der Diode 5 in der erfindungsgemäßen Grundschaltung gemäß Fig. 3C ca. 160 V beträgt.

Sobald der Kondensator 30 und die weiteren Kondensatoren 30₁ und 30₂ zum Zeitpunkt t=120 µsec aufgeladen sind und auch die Wechselspannung ausgeschaltet wird, erfolgt eine Umschaltung zwischen der Parallelverschaltung und der Serienverschaltung des Kondensators 30 und der weiteren Kondensatoren 30₁ und 30₂. Diese Umschaltung in die Serienverschaltung führt zu einer Summation der einzelnen Kondensatorspannungen des Kondensators 30 und der weiteren Kondensatoren 30₁ und 30₂. Somit ergibt sich an der Kathode der Diode 5 in der zweiten Erweiterung der erfindungsgemäßen Schaltung 2 gemäß Fig. 5B eine Sperrspannung von ca. 450 V.

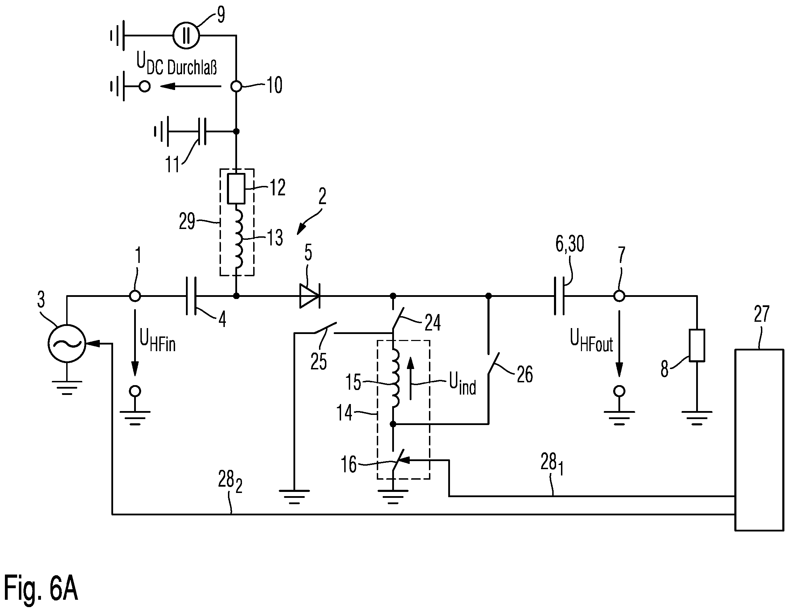

In einer dritten Erweiterung der erfindungsgemäßen Schaltung 2 zum Schalten einer Wechselspannung gemäß Fig. 6A ist zwischen der Kathode der Diode 5 bzw. der pin-Diode 5 und der Serienschaltung 14 aus der ersten Spule 15 und dem ersten Schalter 16 ein fünfter Schalter 24 geschaltet. Zusätzlich ist ein sechster Schalter 25 zwischen der elektrischen Verbindung, die den fünften Schalter 24 mit der ersten Spule 15 verbindet, und dem Massepotenzial geschaltet. Schließlich verbindet ein siebter Schalter 26 die elektrische Verbindung, die die erste Spule 15 mit dem ersten Schalter 16 verbindet, mit der Kathode der Diode 5.

Im Durchlassbetrieb der Diode 5 bzw. der pin-Diode 5 sind ab dem Zeitpunkt t=10 µsec der erste Schalter 16 und der fünfte Schalter 25 jeweils geschlossen. Der sechste Schalter 25 und der siebte Schalter 26 sind ab dem Zeitpunkt t=10 µsec geöffnet.

Die Ansteuerung des fünften Schalters 24, des sechsten Schalters 25 und des siebten Schalters 26 erfolgt wie die Ansteuerung des ersten Schalters 16 durch die Steuerschaltung 27 mittels zugehöriger Signalübertragungsstrecken, die in Fig. 6A der Übersichtlichkeit wegen nicht eingezeichnet sind.

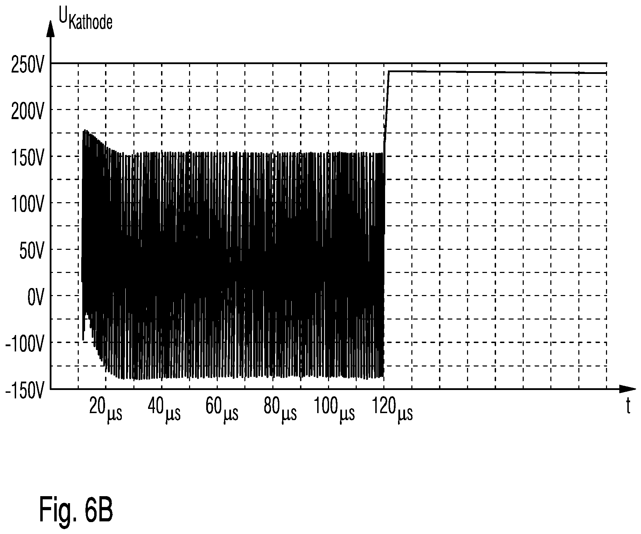

Wie aus Fig. 6B hervorgeht, ergibt sich im Durchlassbetrieb der Diode 5 in der dritten Erweiterung der erfindungsgemäßen Schaltung 2 eine äquivalente Kathodenspannung gegen Massepotenzial wie bei der erfindungsgemäßen Grundschaltung 2 in Fig. 3C. Sie entspricht einer Wechselspannung mit einer Amplitude in Höhe von ca. 150 V.

Zum Zeitpunkt t=120 µsec werden der ersten Schalter 16 und der fünfte Schalter 24 geöffnet und damit der DC-Durchlass-Pfad geöffnet und gleichzeitig die Wechselspannung ausgeschaltet.

Mit der Öffnung des ersten Schalters 16 und des fünften Schalters 24 zum Zeitpunkt t=120 µsec kommt es zu einem abrupten Stromflussabbruch in der ersten Spule 15, der eine Spannung U_{ind} in der ersten Spule 15 induziert. Die Induktionsspannung U_{ind} in der ersten Spule 15 ist entgegengesetzt zur ursprünglichen Stromrichtung durch die erste Spule 15 gerichtet. Damit diese Induktionsspannung U_{ind} nach dem Öffnen des fünften Schalters 24 auf ein Bezugspotenzial bezogen ist, wird bevorzugt gleichzeitig oder zumindest zeitnah zum Öffnen des ersten Schalters 16 und des fünften Schalters 24 der sechste Schalter 25 geschlossen.

Außerdem wird bevorzugt gleichzeitig oder zumindest zeitnah zum Öffnen des ersten Schalters 16 und des fünften Schalters 24 im Zeitpunkt t=120 µsec der siebte Schalter 26 geschlossen. Mit dem Schließen des siebten Schalters 26 wird durch die in der ersten Spule 15 induzierte Spannung U_{ind} der ausgangsseitige Koppelkondensator 6 um die in der ersten Spule 15 induzierte Spannung auf eine Kondensatorspannung von ca. 240 V aufgeladen, wie aus Fig. 6B hervorgeht. Der ausgangsseitige Koppelkondensator 6 bildet hierbei den als Schaltung zum Speichern von elektrischen Ladungen dienenden Kondensator 30.

Damit sich der Kondensator 6 von dieser Kondensatorspannung nicht über den geschlossenen siebten Schalter 26, die erste Spule 15 und den geschlossenen sechsten Schalter 25 zum Massepotenzial entlädt, wird der siebte Schalter 26 zu einem geringfügig späteren Zeitpunkt t=132 µsec wieder geschlossen. Die Kondensatorspannung des Kondensators 6 verharrt somit auf ihrem höheren Wert in Höhe von ca. 240 V, die als Sperrspannung zum sicheren selbstständigen Sperren der Diode 5 bzw. der pin-Diode 5 ausreicht.

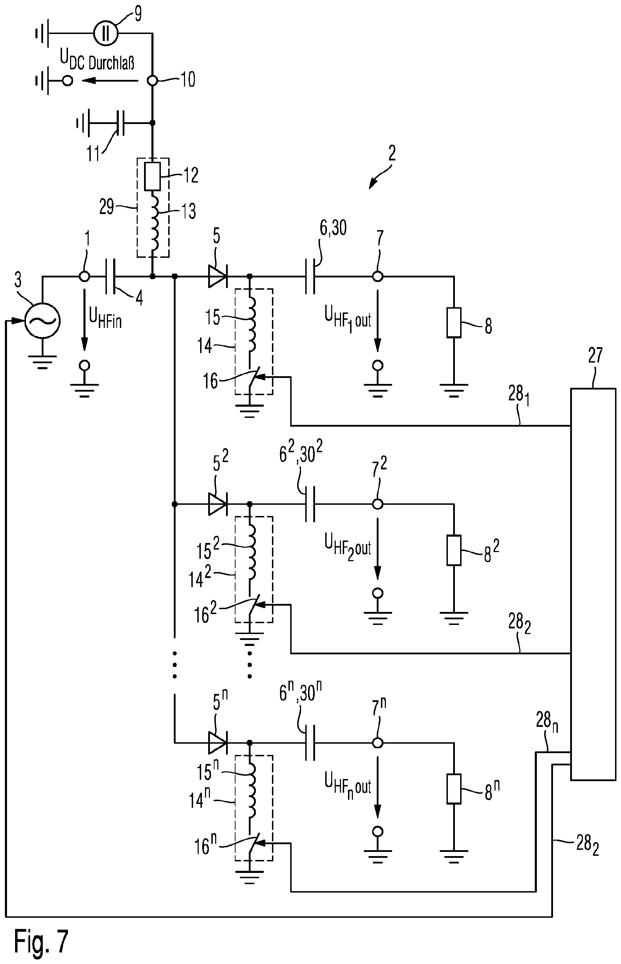

In Fig. 7 ist eine vierte Erweiterung der erfindungsgemäßen Schaltung 2 zum Schalten einer Wechselspannung dargestellt:
Wie die erfindungsgemäße Grundschaltung 2 zum Schalten einer Wechselspannung gemäß Fig. 3A weist die vierte Erweiterung der erfindungsgemäßen Schaltung 2 einen Eingangsanschluss 1 auf, an dem eine Wechselspannungsquelle 3 angeschlossen ist. Am Eingangsanschluss 1 wird eine Wechselspannung, bevorzugt eine Hochfrequenzspannung U_{HFin}, in die erfindungsgemäße Schaltung eingespeist.

Der (Wechselspannungs-)Eingangsanschluss 1 ist mit einem eingangsseitigen Koppelkondensator 4 verbunden, über den einzig eine Wechselspannung, bevorzugt die Hochfrequenzspannung U_{Fin}, in die erfindungsgemäße Schaltung einkoppelbar ist. Der eingangsseitige Koppelkondensator 4 verhindert ebenso ein Auskoppeln einer Gleichspannung aus der erfindungsgemäßen Schaltung 2.

Der eingangsseitige Koppelkondensator 4 ist jeweils mit einer Anzahl n-1 von weiteren Dioden 5²,..., 5ⁿ, bevorzugt von weiteren pin-Dioden 5²,..., 5ⁿ, verbunden. Die Verschaltung der weiteren Dioden 5²,...,5ⁿ entspricht der Verschaltung der Diode 5 in der ersten Variante der erfindungsgemäßen Grundschaltung. Somit ist der eingangsseitige Koppelkondensator zusätzlich mit der Anode der weiteren Dioden 5²,..., 5ⁿ verbunden. Alternativ können in der vierten Erweiterung der erfindungsgemäßen Schaltung auch die anderen Varianten der erfindungsgemäßen Grundschaltung zum Einsatz kommen.

Die Kathode der weiteren parallel verschalteten Dioden 5²,...,5ⁿ ist jeweils über einen zugehörigen ausgangsseitigen Koppelkondensator 6²,...,6ⁿ, der jeweils den die jeweilige Schaltung zum Speichern von elektrischen Ladungen bildenden Kondensator 30²,...,30ⁿ darstellt, mit einem zugehörigen weiteren Ausgangsanschluss 7²,...,7ⁿ verbunden. Am jeweiligen weiteren Ausgangsanschluss 7²,...,7ⁿ liegt jeweils eine ausgangsseitige Wechselspannung U_{HF2out},...,U_{HFnout,} bevorzugt eine ausgangsseitige Hochfrequenzspannung U_{HF2out},..., U_{HFnout}, an. Diese ausgangsseitige Wechselspannung U_{HF2out},..., U_{HFnout} wird einer zugehörigen weiteren Lastimpedanz 8²,...,8ⁿ zugeführt. Bei der Anwendung der vierten Erweiterung der erfindungsgemäßen Schaltung 2 im Automobilbereich entspricht die weitere Lastimpedanz 8²,...,8ⁿ beispielsweise der Impedanz der Zuleitung zu einer elektrischen Zündkerze, der Impedanz des Innenleiters in der elektrischen Zündkerze und der Impedanz im Verbrennungsraum zwischen den beiden Zündkerzenelektroden.

Zwischen der Kathode der weiteren Dioden 5²,..., 5ⁿ und dem Massepotenzial ist jeweils eine zugehörige weitere Serienschaltung 14²,..., 14ⁿ aus einer zugehörigen weiteren Spule 15²,...,15ⁿ und einem zugehörigen weiteren ersten Schalter 16²,...,16² geschaltet. Alternativ zur weiteren Spule 15²,...,15ⁿ kann auch jede andere geeignete Schaltung mit Tiefpassfiltercharakteristik oder jede andere geeignete Schaltung mit einem Widerstand verwendet werden.

Zum Durchschalten der am Eingangsanschluss 1 anliegenden Wechselspannung bzw. Hochfrequenzspannung an den Ausgangsanschluss 7 bzw. an den weiteren Ausgangsanschluss 7²,...,7ⁿ über die zugehörige Diode 5 bzw. die zugehörige weitere Diode 5²,..., 5ⁿ ist ein ausreichender Diodengleichstrom I_{DCDurchlaß} in Durchlassrichtung der Diode 5 bzw. der weiteren Diode 5²,...,5ⁿ erforderlich.

Dieser Diodengleichstrom I_{DCDurchlaß} wird für jede Diode 5 bzw. jede weitere Diode 5²,...,5ⁿ durch eine einzige Gleichspannungsquelle 9 an einem weiteren Eingangsanschluss 10 der erfindungsgemäßen Schaltung 2 erzeugt. Der weitere Eingangsanschluss 10 ist über einen Querkondensator 11 mit einem Widerstand 12 verbunden, der aus der am weiteren Eingangsanschluss 10 anliegenden Gleichspannung U_{DCDurchlaß} einen Diodengleichstrom I_{DCDurchlaß} erzeugt. Zwischen dem Widerstand 12 und der Anode der Diode 5 bzw. der weiteren Diode 5²,..., 5ⁿ ist eine zweite Spule 13 geschaltet. Alternativ zur Einspeisung einer Gleichspannung U_{DCDurchlaß} durch eine Gleichspannungsquelle 9 kann auch direkt der Diodengleichstrom I_{DCDurchlaß} durch eine Gleichstromquelle 17 eingeprägt werden.

Für die einzelnen Bauelemente der vierten Erweiterung der erfindungsgemäßen Schaltung 2 und deren Verschaltung gilt das zu den äquivalenten Bauteilen der erfindungsgemäßen Grundschaltung 2 zum Schalten einer Wechselspannung obig Gesagte äquivalent und wird deshalb an dieser Stelle nicht wiederholt erläutert.

In der vierten Erweiterung der erfindungsgemäße Schaltung 2 gemäß Fig. 7 ist die Steuerschaltung 27 über einzelne Signalübertragungsstrecken 28₁, 28²,28ⁿ jeweils mit den ersten Schaltern 16 bzw. den weiteren ersten Schaltern 16²,...,16ⁿ verbunden. Die Steuerschaltung 27 schließt und öffnet den ersten Schalter 16 bzw. die weiteren ersten Schalter 16²,...,16ⁿ und führt damit die zugehörigen Diode 5 bzw. die zugehörige weitere Diode 5²,...,5ⁿ in den Durchlassbetrieb bzw. in den Sperrbetrieb über.

Die Steuerschaltung 27 kann den ersten Schalter 16 bzw. die weiteren ersten Schalter 16²,...,16ⁿ frühestmöglich wieder einschalten, wenn der transiente Vorgang vom Durchlassbetrieb in den Sperrbetrieb der Diode 5 bzw. der weiteren Dioden 5²,...,5ⁿ sicher abgeschlossen ist. Dies ist der Fall, wenn das Spannungspotenzial in der elektrischen Verbindung zwischen der Diode 5 bzw. der weiteren Dioden 5²,...,5ⁿ und dem Kondensator 30 bzw. der weiteren Kondensatoren, 30²,...,30ⁿ, die jeweils die Schaltung zum Speichern von elektrischen Ladungen darstellen, größer als die von der Spannungsquelle 9 erzeugte Gleichspannung U_{DCDurchlaß} ist. In diesem Fall liegt an der Kathode der Diode 5 bzw. der weiteren Dioden 5²,...,5ⁿ ein ausreichendes Sperrpotenzial an.

Sind in der Schaltung zum Schalten einer Wechselspannung mehrere Gleichspannungsquellen integriert, die ein Sperren der Diode 5 bzw. der weiteren Dioden 5²,...,5ⁿ beeinflussen können, so ist der erste Schalter 16 bzw. der weitere erste Schalter 16²,...,16ⁿ von der Steuerschaltung 27 erst dann frühestmöglich wieder einschaltbar, wenn das Spannungspotenzial in der elektrischen Verbindung zwischen der Diode 5 bzw. der weiteren Dioden 5²,...,5ⁿ und dem Kondensator 30 bzw. der weiteren Kondensatoren, 30²,...,30ⁿ größer als die größte von allen erzeugten Gleichspannungen der in der Schaltung realisierten Gleichspannungsquellen ist.

Die Steuerschaltung 27, die die Wechselspannungsquelle 3 über die Signalübertragungsstrecke 28₂ ein- und ausschaltet, kann die Wechselspannungsquelle 3 gegenüber dem Öffnen des ersten Schalters 16 bzw. der weiteren ersten Schalter 16²,...,16ⁿ verzögert ausschalten. Dieses "Nachbrennen" der Wechselspannung wird spätestens über die Steuerschaltung 27 durch Ausschalten der Wechselspannungsquelle 3 beendet, wenn das Spannungspotenzial in der elektrischen Verbindung zwischen der Diode 5 bzw. der weiteren Dioden 5²,...,5ⁿ und dem Kondensator 30 bzw. der weiteren Kondensatoren, 30²,...,30ⁿ größer als die größte Spannung von allen Spannungen ist, die jeweils von in der Schaltung realisierten Gleichspannungsquellen erzeugt werden.

Die kathodenseitige Beschaltung der Diode 5 bzw. der weiteren Dioden 5²,...,5ⁿ der vierten Erweiterung der erfindungsgemäßen Schaltung 2 in Fig. 7, die der kathodenseitigen Beschaltung der Diode 5 in der ersten Variante der erfindungsgemäßen Grundschaltung 2 zum Schalten einer Wechselspannung gemäß der Fig. 3A entspricht, kann alternativ auch entsprechend der kathodenseitigen Beschaltung der Diode 5 der ersten, zweiten oder dritten Erweiterung der erfindungsgemäßen Schaltung 2 zum Schalten einer Wechselspannung gemäß der Figuren 4A, 5A und 6A ausgeführt sein. Die Steuerschaltung 27 ist in diesen Fällen um die Ansteuerung der dabei erforderlichen weiteren Schalter zu ergänzen.

In einer bevorzugten Anwendung wird die in der Wechselspannungsquelle 3 erzeugte Wechselspannung U_{HFin} im zyklischen Betrieb über zyklisch in den Durchlassbetrieb geschaltete Dioden 5,5²,...,5ⁿ zyklisch an die einzelnen Ausgangsanschlüsse 7,7²,..,7ⁿ geschaltet und damit verteilt. Neben einem zyklischen Betrieb ist auch jede beliebige und technisch sinnvolle Ansteuerungsreihenfolge der einzelnen Dioden 5,5²,...,5ⁿ möglich. Schließlich können auch mehrere Dioden 5,5²,...,5ⁿ gleichzeitig angesteuert werden und damit die erzeugte Wechselspannung U_{HFin} gleichzeitig an mehrere Ausgangsanschlüsse 7,7²,..,7ⁿ geschaltet und damit verteilt werden.

Obwohl die vorliegende Erfindung anhand bevorzugter Ausführungsbeispiele vorstehend vollständig beschrieben wurde, ist sie darauf nicht beschränkt, sondern im Rahmen der beigefügten Patentansprüche auf vielfältige Art und Weise modifizierbar.

### Bezugszeichenliste

- 1: Eingangsanschluss
- 2: Schaltung zum Schalten einer Wechselspannung
- 3: Wechselspannungsquelle
- 4: eingangsseitiger Koppelkondensator
- 5: Diode bzw. pin-Diode
- 5²,..,5ⁿ: weitere Diode bzw. weitere pin-Diode
- 6: ausgangsseitiger Koppelkondensator
- 6²,..,6ⁿ: weiter ausgangsseitiger Koppelkondensator
- 7: Ausgangsanschluss
- 7²,..,7ⁿ: weiterer Ausgangsanschluss
- 8: Lastimpedanz
- 8²,..,8ⁿ: weitere Lastimpedanz
- 9: Gleichspannungsquelle
- 10: weiterer Eingangsanschluss
- 11: Querkondensator
- 12: Widerstand
- 13: zweite Spule
- 14: Serienschaltung
- 14²,..,14ⁿ: weitere Serienschaltung
- 15: erste Spule
- 15²,..,15ⁿ: weitere erste Spule
- 16: erster Schalter
- 16²,..,16ⁿ: weiterer erster Schalter
- 18: Serienschaltung
- 19: dritte Spule
- 20: Verschaltung
- 20': Verschaltung
- 21₁,21₂,..,21ₙ: zweiter Schalter
- 22₁,22₂,.., 22ₙ: dritter Schalter
- 23₁,23₂,..,23ₙ: vierter Schalter
- 24: fünfter Schalter
- 25: sechster Schalter
- 26: siebter Schalter
- 27: Steuerschaltung
- 28₁,28₂: Signalleitung
- 28²,...,28ⁿ: weitere Signalleitung
- 29: Serienschaltung
- 30: Kondensator
- 30²,..,30ⁿ: weiterer Kondensator

## Patentansprüche

1. Schaltung (2) zum Schalten einer Wechselspannung umfassend einen mit einer Wechselspannungsquelle (3) verbindbaren Eingangsanschluss (1), einen mit einer Lastimpedanz (8) verbindbaren Ausgangsanschluss (7), eine erste Serienschaltung umfassend eine Diode (5) und eine Schaltung (6, 30) zum Speichern von elektrischen Ladungen, wobei die erste Serienschaltung einen ersten Endanschluss, der mit dem Eingangsanschluss (1) verbunden ist, und einen zweiten Endanschluss, der mit dem Ausgangsanschluss (7) verbunden ist, aufweist, eine Gleichspannungsquelle (9), welche an eine elektrische Verbindung zwischen der Diode (5) und dem Eingangsanschluss (1) oder an eine elektrische Verbindung zwischen der Diode (5) und dem Ausgangsanschluss (7) angeschlossen ist und derart eingerichtet ist, einen Gleichstrom in der Diode (5) einzuprägen, und einen ersten Schalter (16), welcher mit einem Anschluss an einer elektrischen Verbindung zwischen der Diode (5) und der Schaltung zum Speichern von elektrischen Ladungen angeschlossen ist und welcher derart eingerichtet ist, zwischen einem Schaltzustand, in dem ein von einem Bezugspotential abhängiges Potential an der elektrischen Verbindung zwischen der Diode (5) und der Schaltung (6, 30) zum Speichern von elektrischen Ladungen anliegt, und einem Schaltzustand, in dem ein elektrisches Schwebepotential in der elektrischen Verbindung zwischen der Diode (5) und der Schaltung zum Speichern von elektrischen Ladungen anliegt, zu schalten,
**dadurch gekennzeichnet,**
**dass** weitere erste Serienschaltungen umfassend jeweils eine weitere Diode (5²,...,5ⁿ) und eine weitere Schaltung (6²,...,6ⁿ, 30²,...,30ⁿ) zum Speichern von elektrischen Ladungen vorgesehen sind, wobei jede weitere Serienschaltung jeweils einen ersten Endanschluss und einen zweiten Endanschluss aufweist, wobei jeder erste Endanschluss mit dem Eingangsanschluss (1) verbunden ist und jeder zweite Endanschluss jeweils mit einem weiteren Ausgangsanschluss (7²,...,7ⁿ) verbunden ist, der jeweils mit einer weiteren Lastimpedanz (8²,...,8ⁿ) verbindbar ist und dass jeweils ein weiterer erster Schalter (16²,...,16ⁿ) mit einem Anschluss an der elektrischen Verbindung zwischen der jeweiligen weiteren Diode (5²,...,5ⁿ) und der jeweiligen weiteren Schaltung zum Speichern von elektrischen Ladungen angeschlossen ist und welcher derart eingerichtet ist, zwischen einem Schaltzustand, in dem ein vom Bezugspotential abhängiges Potential an der elektrischen Verbindung zwischen der jeweiligen weiteren Diode (5²,...,5ⁿ) und der jeweiligen weiteren Schaltung zum Speichern von elektrischen Ladungen anliegt, und einem Schaltzustand, in dem ein elektrisches Schwebepotential in der elektrischen Verbindung zwischen der jeweiligen weiteren Diode (5²,...,5ⁿ) und der jeweiligen weiteren Schaltung (6²,...,6ⁿ, 30²,...,30ⁿ) zum Speichern von elektrischen Ladungen anliegt, zu schalten,
um dadurch jede einzelne weitere Diode (5²,...,5ⁿ) jeweils separat in Durchlass- oder Sperrrichtung zu schalten.

2. Schaltung (2) nach Patentanspruch 1,
**dadurch gekennzeichnet,**
**dass** der erste Schalter (16) ein erster Einschalter oder ein erster Ausschalter ist.

3. Schaltung (2) nach Patentanspruch 1 oder 2,
**dadurch gekennzeichnet,**
**dass** zwischen der Gleichungsspannungsquelle (9) und der elektrischen Verbindung zwischen der Diode (5) und dem Eingangsanschluss (1) oder zwischen der Gleichungsspannungsquelle (9) und der elektrischen Verbindung zwischen der Diode (5) und dem Ausgangsanschluss (7) eine Schaltung mit einer Tiefpassfiltercharakteristik oder eine Schaltung mit einem Widerstand und zwischen dem ersten Schalter (16) und der elektrischen Verbindung zwischen der Diode (5) und der Schaltung zum Speichern von elektrischen Ladungen eine Schaltung mit einer Tiefpassfiltercharakteristik oder eine Schaltung mit einem Widerstand geschaltet sind.

4. Schaltung (2) nach Patentanspruch 3,
**dadurch gekennzeichnet,**
**dass** die Schaltung mit der Tiefpassfiltercharakteristik zwischen dem ersten Schalter (16) und der elektrischen Verbindung zwischen der Diode (5) und der Schaltung zum Speichern von elektrischen Ladungen eine erste Spule (15) und die Schaltung mit der Tiefpassfiltercharakteristik zwischen der Gleichungsspannungsquelle (9) und der elektrischen Verbindung zwischen der Diode (5) und dem Eingangsanschluss (1) oder die Schaltung mit der Tiefpassfiltercharakteristik zwischen der Gleichungsspannungsquelle (9) und der elektrischen Verbindung zwischen der Diode (5) und dem Ausgangsanschluss (7) jeweils eine zweite Spule (13) sind.

5. Schaltung (2) nach einem der Patentansprüche 1 bis 4,
**dadurch gekennzeichnet,**
**dass** die Schaltung zum Speichern von elektrischen Ladungen einen Kondensator (30) umfasst.

6. Schaltung (2) nach einem der Patentansprüche 1 bis 4,
**dadurch gekennzeichnet,**
**dass** die Schaltung zum Speichern von elektrischen Ladungen einen Kondensator (30) und wenigstens einen weiteren Kondensator (30₁, 30₂) umfasst, die über jeweils einen in einer elektrischen Verbindung zur Diode (5) angeordneten zweiten Schalter (21₁, 21₂) und jeweils einen in einer elektrischen Verbindung zum Ausgangsanschluss (7) oder zum Eingangsanschluss (1) angeordneten dritten Schalter (22₁, 22₂) zueinander parallel schaltbar sind.

7. Schaltung (2) nach Patentanspruch 6,
**dadurch gekennzeichnet,**
**dass** der Kondensator (30) und der wenigstens eine weitere Kondensator (30₁, 30₂) über vierte Schalter (23₁, 23₂) zueinander seriell schaltbar sind.

8. Schaltung (2) nach Patentanspruch 5,
**dadurch gekennzeichnet,**
**dass** zwischen dem Bezugspotential und einer elektrischen Verbindung zwischen der Diode (5) und dem Kondensator (30) eine zweite Serienschaltung umfassend eine dritte Spule (19) und eine Verschaltung (20) aus mehreren weiteren Kondensatoren (30₁, 30₂, 30₃) geschaltet ist.

9. Schaltung (2) nach Patentanspruch 8,
**dadurch gekennzeichnet,**
**dass** die weiteren Kondensatoren (30₁, 30₂, 30₃) jeweils über einen in einer elektrischen Verbindung zur Diode (5) angeordneten zweiten Schalter (21₁, 21₂) und über jeweils einen in einer elektrischen Verbindung zum Bezugspotential angeordneten dritten Schalter (22₁, 22₂) zueinander parallel schaltbar sind.

10. Schaltung (2) nach Patentanspruch 8 oder 9,
**dadurch gekennzeichnet,**
**dass** die weiteren Kondensatoren (30₁, 30₂, 30₃) über vierte Schalter (23₁, 23₂), die jeweils zwischen Anschlüssen von zwei weiteren Kondensatoren (30₁, 30₂, 30₃) geschaltet sind, zueinander seriell schaltbar sind.

11. Schaltung (2) nach Patentanspruch 4,
**dadurch gekennzeichnet,**
**dass** zwischen der ersten Spule ((15) und der elektrischen Verbindung zwischen der Diode (5) und der Schaltung zum Speichern von elektrischen Ladungen ein fünfter Schalter (24) geschaltet ist.

12. Schaltung (2) nach Patentanspruch 11,
**dadurch gekennzeichnet,**
**dass** zwischen einer den fünften Schalter (24) und die erste Spule (15) verbindenden elektrischen Verbindung und dem Bezugspotential ein sechster Schalter (25) und zwischen einer die erste Spule (15) und den ersten Schalter (16) verbindenden elektrischen Verbindung und der elektrischen Verbindung zwischen der Diode (5) und der Schaltung zum Speichern von elektrischen Ladungen ein siebter Schalter (26) geschaltet sind.

13. Schaltung (2) nach einem der Patentansprüche 1 bis 12,
**dadurch gekennzeichnet,**
**dass** eine Steuerschaltung (27), die mit dem ersten Schalter (16) und jedem weiteren ersten Schalter (16²,..., 16ⁿ) verbunden ist, derart eingerichtet ist, dass sie den ersten Schalter (16) und jeden weiteren ersten Schalter (16²,...,16ⁿ) jeweils ein- und ausschaltet, wobei der erste Schalter (16) und jeder weitere erste Schalter (16²,...,16ⁿ) jeweils zu unterschiedlichen Zeiten eingeschaltet sind.

14. Schaltung (2) nach Patentanspruch 13,
**dadurch gekennzeichnet,**
**dass** die Steuerschaltung (27) derart eingerichtet ist, dass der erste Schalter (16) oder jeder weitere erste Schalter (16²,...,16ⁿ) erst eingeschaltet wird, wenn der erste Schalter (16) und jeder weitere erste Schalter (16²,...,16ⁿ) ausgeschaltet sind.

15. Schaltung (2) nach Patentanspruch 13 oder 14,
**dadurch gekennzeichnet,**
**dass** die Steuerschaltung (27) derart eingerichtet ist, dass eine Ausschaltzeit des ersten Schalters oder jedes weiteren ersten Schalters jeweils mindestens solange andauert, bis ein Spannungspotential in der elektrischen Verbindung zwischen der Diode (5) und der Schaltung zum Speichern von elektrischen Ladungen bzw. in der elektrischen Verbindung zwischen der weiteren Diode (5²,...,5ⁿ) und der weiteren Schaltung zum Speichern von elektrischen Ladungen jeweils größer als eine größte Spannung von allen in der Schaltung (2) enthaltenen Gleichspannungsquellen (9) ist.

16. Gesteuerte Wechselspannungsquelle umfassend eine Wechselspannungsquelle (3), eine Schaltung (2) nach einem der Patentansprüche 13 bis 15, deren Eingangsanschluss (1) mit der Wechselspannungsquelle (3) verbunden ist, wobei die Steuerschaltung (27) derart eingerichtet ist, dass sie die Wechselspannungsquelle (3) ein- und ausschaltet.

17. Gesteuerte Wechselspannungsquelle nach Patentanspruch 16,
**dadurch gekennzeichnet,**
**dass** die Steuerschaltung (27) derart eingerichtet ist, dass sie die Wechselspannungsquelle (3) solange eingeschaltet lässt, bis das Spannungspotential in der elektrischen Verbindung zwischen der Diode (5) und der Schaltung zum Speichern von elektrischen Ladungen bzw. in der elektrischen Verbindung zwischen der weiteren Diode (5²,...,5ⁿ) und der weiteren Schaltung zum Speichern von elektrischen Ladungen jeweils größer als eine größte Spannung von allen in der Schaltung enthaltenen Gleichspannungsquellen (9) ist.

18. Motoransteuerschaltung mit einer Wechselspannungsquelle (3) einer Schaltung (2) gemäß einem der Patentansprüche 1 bis 15 und einer Anzahl von elektrischen Zündkerzen, wobei die Wechselspannungsquelle (3) mit dem Eingangsanschluss (1) der Schaltung (2) und jede elektrische Zündkerze jeweils mit dem Ausganganschluss (7) bzw. mit einem der weiteren Ausgangsanschlüsse (7²,...,7ⁿ) der Schaltung (2) verbunden sind.

## Claims

1. Circuit (2) for switching an alternating voltage comprising an input connection (1) connectable to an alternating voltage source (3), an output connection (7) connectable to a load impedance (8), a first series circuit comprising a diode (5) and a circuit (6, 30) for storing electrical loads, wherein the first series circuit has a first end connection connected to the input connection (1) and a second end connection connected to the output connection (7), a DC voltage source (9) connected to an electrical connection between the diode (5) and the input connection (1), or to an electrical connection between the diode (5) and the output connection (7), and designed to generate a direct current in the diode (5), and a first switch (16) connected to an electrical connection between the diode (5) and the circuit for storing electrical loads and designed to switch between a switching state in which a potential dependent on a reference potential is applied to the electrical connection between the diode (5) and the circuit (6, 30) for storing electrical loads, and a switching state, in which there is an electrical floating potential in the electrical connection between the diode (5) and the circuit for storing electrical loads,
**characterized in that,**
further first series circuits each comprising a further diode (5², ..., 5ⁿ) and a further circuit (6², ..., 6ⁿ, 30², ..., 30ⁿ) for storing electrical loads are provided, wherein each further series circuit has a first end connection and a second end connection, each first end connection being connected to the input connection (1) and each second end connection being connected to a further output connection (7², ..., 7ⁿ), each of the latter being connectable to a further load impedance (8², ..., 8ⁿ) and wherein, in each case, a further first switch (16²,..., 16ⁿ) is connected to the electrical connection between the respective further diode (5², ..., 5ⁿ) and the respective further circuit for storing electrical loads, and is designed to switch between a switching state in which a potential dependent on the reference potential is applied at the electrical connection between the respective further diode (5², ..., 5ⁿ) and the respective further circuit for storing electrical loads, and a switching state in which an electrical floating potential is applied in the electrical connection between the respective further diode (5², ..., 5ⁿ) and the respective further circuit (6², ..., 6ⁿ, 30², ..., 30ⁿ) for storing electrical loads, in order thus to switch each individual further diode (5², ..., 5ⁿ) separately in the forward or reverse direction.

2. Circuit (2) according to claim 1,
**characterized in that**
the first switch (16) is a first ON switch or a first OFF switch.

3. Circuit (2) according to claim 1 or 2,
**characterized in that**
a circuit with a low-pass filter characteristic or a circuit with a resistor is switched between the DC voltage source (9) and the electrical connection between the diode (5) and the input connection (1), or between the DC voltage source (9) and the electrical connection between the diode (5) and the output connection (7), while a circuit with a low-pass filter characteristic or a circuit with a resistor is switched between the first switch (16) and the electrical connection between the diode (5) and the circuit for storing electrical loads.

4. Circuit (2) according to claim 3,
**characterized in that**
the circuit with the low-pass filter characteristic between the first switch (16) and the electrical connection between the diode (5) and the circuit for storing electrical loads has a first coil (15), while the circuit with the low-pass filter characteristic between the DC voltage source (9) and the electrical connection between the diode (5) and the input connection (1), or the circuit with the low-pass filter characteristic between the DC voltage source (9) and the electrical connection between the diode (5) and the output connection (7), has a second coil (13).

5. Circuit (2) according to one of claims 1 to 4,
**characterized in that**
the circuit for storing electrical loads comprises a capacitor (30).

6. Circuit (2) according to one of claims 1 to 4,
**characterized in that**
the circuit for storing electrical loads comprises a capacitor (30) and at least one further capacitor (30₁, 30₂) each of which may be respectively switched in parallel to one another via a second switch (21₁, 21₂) electrically connected with the diode (5) or via third switches (22₁, 22₂) electrically connected with the output connection (7) or with the input connection (1).

7. Circuit (2) according to claim 6,
**characterized in that**
the capacitor (30) and the at least one further capacitor (30₁, 30₂) may be connected in series to one another via fourth switches (23₁, 23₂).

8. Circuit (2) according to claim 5,
**characterized in that**
a second series circuit comprising a third coil (19) and an interconnection (20) comprising several further capacitors (30₁, 30₂, 30₃) is switched between the reference potential and an electrical connection between the diode (5) and the capacitor (30).

9. Circuit (2) according to claim 8,
**characterized in that**
the further capacitors (30₁, 30₂, 30₃) may be respectively switched in parallel to one another via a second switch (21₁, 21₂) electrically connected to the diode (5), and via a third switch (22₁, 22₂) electrically connected to the reference potential.

10. Circuit (2) according to claim 8 or 9,
**characterized in that**
the further capacitors (30₁, 30₂, 30₃) may be switched in series to one another via fourth switches (23₁, 23₂), which are each switched between two further capacitors (30₁, 30₂, 30₃).

11. Circuit (2) according to claim 4,
**characterized in that**
a fifth switch (24) is connected between the first coil (15) and the electrical connection between the diode (5) and the circuit for storing electrical loads.

12. Circuit (2) according to claim 11,
**characterized in that**
a sixth switch (25) is switched between an electrical connection connecting the fifth switch (24) and the first coil (15) and the reference potential, while a seventh switch (26) is switched between an electrical connection connecting the first coil (15) and the first switch (16) and the electrical connection between the diode (5) and the circuit for storing electrical loads.

13. Circuit (2) according to one of the claims 1 to 12,
**characterized in that**
a control circuit (27) which is connected to the first switch (16) and each further first switch (16², ..., 16ⁿ) is set up in such a way that it switches the first switch (16) and each further first switch (16², ..., 16ⁿ) on and off, wherein the first switch (16) and each further first switch (16², ..., 16ⁿ) is switched on at different times.

14. Circuit (2) according to claim 13,
**characterized in that**
the control circuit (27) is set up in such a way that the first switch (16) or each further first switch (16², ..., 16ⁿ) is only switched on when the first switch (16) and each further first switch (16², ..., 16ⁿ) is switched off.

15. Circuit (2) according to claim 13 or 14,
**characterized in that**
the control circuit (27) is set up in such a way that a switch-off time of the first switch or each further first switch lasts at least until a voltage potential in the electrical connection between the diode (5) and the circuit for storing electrical loads, or in the electrical connection between the further diode (5², ..., 5ⁿ) and the further circuit for storing electrical loads, is respectively greater than a maximum voltage of all the DC voltage sources (9) contained in the circuit (2).

16. Controlled AC voltage source comprising an AC voltage source (3), a circuit (2) according to one of claims 13 to 15, wherein the input terminal (1) is connected to the AC voltage source (3), and wherein the control circuit (27) is set up so that it switches the AC voltage source (3) on and off.

17. Controlled AC voltage source according to claim 16,
**characterized in that**
the control circuit (27) is set up so that it leaves the AC voltage source (3) switched on until the voltage potential in the electrical connection between the diode (5) and the circuit for storing electrical loads, or in the electrical connection between the further diode (5², ..., 5ⁿ) and the further circuit for storing electrical loads, is respectively greater than a maximum voltage of all DC voltage sources (9) contained in the circuit.

18. Engine control circuit with an AC voltage source (3), a circuit (2) according to one of the claims 1 to 15, and a number of electrical spark plugs, wherein the AC voltage source (3) is connected to the input terminal (1) of the circuit (2) and each electrical spark plug is respectively connected to the output connection (7) or to one of the further direct output connections (7², ..., 7ⁿ) of the circuit (2).

## Revendications

1. Circuit (2) pour le branchement d'une tension alternative comprenant une borne d'entrée (1) pouvant être reliée à une source de tension alternative (3), une borne de sortie (7) pouvant être reliée à une impédance de charge (8), un premier circuit en série comprenant une diode (5) et un circuit (6, 30) pour l'accumulation de charges électriques, dans lequel le premier circuit en série comprend une première borne d'extrémité, qui est reliée à la borne d'entrée (1), et une deuxième borne d'extrémité, qui est reliée à la borne de sortie (7), une source de tension continue (9) qui est raccordée à une liaison électrique entre la diode (5) et le borne d'entrée (1) ou à une liaison électrique entre la diode (5) et la borne de sortie (7) et qui est conçue de façon à appliquer un courant continu à la diode (5), et un premier commutateur (16), qui est raccordé, avec une première borne, à une liaison électrique entre la diode (5) et le circuit, pour l'accumulation de charges électriques et qui est conçu pour commuter entre un état de commutation, dans lequel un potentiel dépendant d'un potentiel de référence est appliqué à la liaison électrique entre la diode (5) et le circuit (6, 30) pour l'accumulation de charges électriques, et un état de commutation dans lequel un potentiel électrique de suspension est appliqué dans la liaison électrique entre la diode (5) et le circuit pour l'accumulation de charges électriques,
**caractérisé en ce que**
d'autres premiers circuits en série comprenant chacun une autre diode (5²... 5ⁿ) et un autre circuit (6²... 6ⁿ, 30²... 30ⁿ) pour l'accumulation de charges électriques sont prévues, dans lequel chaque autre circuit en série comprend une première borne d'extrémité et une deuxième bord d'extrémité, dans lequel chaque première borne d'extrémité est reliée avec la borne d'entrée (1) et chaque deuxième borne d'extrémité est reliée avec une autre borne de sortie (7²... 7ⁿ), qui peut être relié à une autre impédance de charge (8²... 8ⁿ) et **en ce qu'**un autre premier commutateur (16²... 16ⁿ) respectif est raccordé, avec une borne, à la liaison électrique entre l'autre diode (5²... 5ⁿ) respective et l'autre circuit correspondant pour l'accumulation de charges électriques et qui est conçu de façon à commuter entre un état de commutation, dans lequel un potentiel dépendant du potentiel de référence est appliqué à la liaison électrique entre l'autre diode (5²... 5ⁿ) respective et l'autre circuit respectif pour l'accumulation de charges électriques et un état de commutation dans lequel un potentiel électrique de suspension est appliqué dans la liaison électrique entre l'autre diode (5²... 5ⁿ) respective et l'autre circuit (6²... 6ⁿ, 30²... 30ⁿ) respectif pour l'accumulation de charges électriques, afin de brancher chaque autre diode (5²... 5ⁿ) séparément dans le sens passant ou le sens de blocage.

2. Circuit (2) selon la revendication 1,
**caractérisé en ce que**
le premier commutateur (16) est un premier interrupteur de mise en marche ou un premier coupe-circuit.

3. Circuit (2) selon la revendication 1 ou 2,
**caractérisé en ce que**
entre la source de tension continue (9) et la liaison électrique entre la diode (5) et la borne d'entrée (1) ou entre la source de tension continue (9) et la liaison électrique entre la diode (5) et la borne de sortie (7), est branché un circuit avec une caractéristique de filtre passe-base ou un circuit avec une résistance et entre le premier commutateur (16) et la liaison électrique entre la diode (5) et le circuit pour l'accumulation de charges électriques est branché un circuit avec une caractéristique de filtre passe-bas ou un circuit avec une résistance.

4. Circuit (2) selon la revendication 3,
**caractérisé en ce que**
le circuit avec la caractéristique de filtre passe-bas entre le premier commutateur (16) et la liaison électrique entre la diode (5) et le circuit pour l'accumulation de charges électriques est une première bobine (15) et le circuit avec la caractéristique de filtre passe-bas entre la source de tension continue (9) et la liaison électrique entre la diode (5) et la borne d'entrée (1) ou le circuit avec la caractéristique de filtre passe-bas entre la source de tension continue (9) et la liaison électrique entre la diode (5) et la borne de sortie (7) est une deuxième bobine (13).

5. Circuit (2) selon l'une des revendications 1 à 4,
**caractérisé en ce que**
le circuit comprend un condensateur (30) pour l'accumulation de charges électriques.

6. Circuit (2) selon l'une des revendications 1 à 4,
**caractérisé en ce que**
le circuit pour l'accumulation de charges électriques comprend un condensateur (30) et au moins un autre condensateur (30₁... 30₂), qui peuvent être branchés en parallèle entre eux chacun par l'intermédiaire d'un deuxième commutateur (21₁, 21₂) disposé dans une liaison électrique avec la diode (5) et d'un troisième commutateur (22₁, 22₂) disposé dans une liaison électrique avec la borne de sortie (7) ou avec la borne d'entrée (1).

7. Circuit (2) selon la revendication 6,
**caractérisé en ce que**
le condensateur (30) et l'au moins un autre condensateur (30₁, 30₂) peuvent être branchés en série entre eux par l'intermédiaire de quatrièmes commutateurs (23₁, 23₂).

8. Circuit (2) selon la revendication 5,
**caractérisé en ce que**
entre le potentiel de référence et une liaison électrique entre la diode (5) et le condensateur (30), est branché un deuxième circuit en série comprenant une troisième bobine (19) et un câblage (20) constitué de plusieurs autres condensateurs (30₁, 30₂, 30₃).

9. Circuit (2) selon la revendication 8,
**caractérisé en ce que**
les autres condensateurs (30₁, 30₂, 30₃) peuvent être branchés en parallèle entre eux par l'intermédiaire d'un deuxième commutateur (21₁, 21₂) disposé dans une liaison électrique avec la diode (5) et par l'intermédiaire d'un troisième commutateur (22₁, 22₂) disposé dans une liaison électrique avec le potentiel de référence.

10. Circuit (2) selon la revendication 8 ou 9,
**caractérisé en ce que**
les autres condensateurs (30₁, 30₂, 30₃) peuvent être branchés en série entre eux par l'intermédiaire de quatrièmes commutateurs (23₁, 23₂) qui sont branchés chacun a=entre des bornes de deux autres condensateurs (30₁, 30₂, 30₃).

11. Circuit (2) selon la revendication 4,
**caractérisé en ce que**
entre la première bobine (15) et la liaison électrique entre la diode (5) et le circuit pour l'accumulation de charges électriques, est branché un cinquième commutateur (24).

12. Circuit (2) selon la revendication 11,
**caractérisé en ce que**
entre la liaison électrique reliant le cinquième commutateur (24) et la première bobine (15) et le potentiel de référence est branché un sixième commutateur (25) et entre une liaison électrique reliant la première bobine (15) et le premier commutateur (16) et la liaison électrique entre la diode (5) et le circuit pour l'accumulation de charges électriques, est branché un septième commutateur (26).

13. Circuit (2) selon l'une des revendications 1 à 12,
**caractérisé en ce que**
un circuit de commande (27), qui est relié avec le premier commutateur (16) et chaque autre premier commutateur (16²... 16ⁿ), est conçu de façon à activer et désactiver le premier commutateur (16) et chaque autre premier commutateur (16²... 16ⁿ), dans lequel le premier commutateur (16) et chaque autre premier commutateur (16²... 16ⁿ) sont activés à des moments différents.

14. Circuit (2) selon la revendication 13,
**caractérisé en ce que**
le circuit de commande (27) est conçu de façon à ce que le premier commutateur (16) ou chaque autre premier commutateur (16²... 16ⁿ) ne soit activé que lorsque le premier commutateur (16) et chaque autre premier commutateur (16²... 16ⁿ) sont désactivés.

15. Circuit (2) selon la revendication 13 ou 14,
**caractérisé en ce que**
le circuit de commande (27) est conçu de façon à ce qu'un temps de désactivation du premier commutateur ou de chaque autre premier commutateur dure au moins jusqu'à ce qu'un potentiel de tension dans la liaison électrique entre la diode (5) et le circuit pour l'accumulation de charges électriques resp. dans la liaison électrique entre l'autre diode (5²... 5ⁿ) et l'autre circuit pour l'accumulation de charges électriques est supérieur à la tension la plus grande de toutes les sources de tension continue (9) contenues dans le circuit (2).

16. Source de tension alternative contrôlée comprenant une source de tension alternative (3), un circuit (2) selon l'une des revendications 13 à 15, dont la borne d'entrée (1) est reliée avec la source de tension alternative (3), dans lequel le circuit de commande (27) est conçu de façon à activer et désactiver la source de tension alternative (3).

17. Source de tension alternative contrôlée selon la revendication 16,
**caractérisée en ce que**
le circuit de commande (27) est conçu de façon à laisser la source de tension alternative (3) activée jusqu'à ce que le potentiel de référence dans la liaison électrique entre la diode (5) et le circuit pour l'accumulation de charges électriques resp. dans la liaison électrique entre l'autre diode (5²... 5ⁿ) et l'autre circuit pour l'accumulation de charges électriques est supérieure à la tension la plus grande de toutes les sources de tension continue (9) contenues dans le circuit.

18. Circuit de commande de moteur avec une source de tension alternative (3) d'un circuit (2) selon l'une des revendications 1 à 15 et plusieurs bougies d'allumage électriques, dans lequel la source de tension alternative (3) est reliée avec la borne d'entrée (1) du circuit (2) et chaque bougie d'allumage est reliée avec une borne de sortie (7) resp. avec une des autres bornes de sortie (7²... 7ⁿ) du circuit (2).
